# EUROPEAN PATENT APPLICATION

(11) **EP 2 164 115 A1**
(43) Date of publication of application: **17.03.2010**
(21) Application number: 08765565.0
(22) Date of filing: 13.06.2008
(51) Int. Cl.: H01L 33/00

(54) **NITRIDE SEMICONDUCTOR LIGHT EMITTING ELEMENT AND METHOD FOR MANUFACTURING NITRIDE SEMICONDUCTOR**

(30) Priority: 15.06.2007 JP 2007158959; 15.06.2007 JP 2007158973; 15.06.2007 JP 2007158974; 15.06.2007 JP 2007158954; 15.06.2007 JP 2007158513; 04.10.2007 JP 2007260926; 04.10.2007 JP 2007260933; 05.10.2007 JP 2007262280; 07.11.2007 JP 2007289719
(71) Applicant: Rohm Co., Ltd., Kyoto-shi, Kyoto 615-8585 (JP)
(72) Inventor: NAKANISHI, Yasuo, Kyoto-shi Kyoto 615-8585 (JP); NAKATA, Shunji, Kyoto-shi Kyoto 615-8585 (JP); FUJIWARA, Tetsuya, Kyoto-shi Kyoto 615-8585 (JP); SENDA, Kazuhiko, Kyoto-shi Kyoto 615-8585 (JP); SONOBE, Masayuki, Kyoto-shi Kyoto 615-8585 (JP)
(74) Representative: TBK-Patent
(86) International application number: PCT/JP2008/060855
(87) International publication number: WO 2008/153130

(57) **Abstract**

Provided are a nitride semiconductor light emitting element having a nitride semiconductor layered on an AlN buffer layer with improved qualities such as crystal quality and with improved light emission output, and a method of manufacturing a nitride semiconductor. An AlN buffer layer (2) is formed on a sapphire substrate (1), and nitride semiconductors of an n-type AlGaN layer (3), an InGaN/GaN active layer (4) and a p-type GaN layer (5) are layered in sequence on the buffer layer (2). An n-electrode (7) is formed on a surface of the n-type AlGaN layer (3), and a p-electrode (6) is formed on the p-type GaN layer (5). The n-type AlGaN layer (3) serves as a cladding layer for confining light and carriers. The AlN buffer layer (2) is manufactured by alternately supplying an Al material and an N material at a growing temperature of 900°C or higher.

## Description

### TECHNICAL FIELD

The present invention relates to a nitride semiconductor light emitting element having a layered body formed of a nitride semiconductor on an AlN buffer layer of a nitride semiconductor and a method for manufacturing the nitride semiconductor.

### BACKGROUND ART

Active development has been conducted on a semiconductor element called as gallium nitride compound semiconductor, that is, so-called III-V nitride semiconductor (hereinafter referred to as a nitride semiconductor). The nitride semiconductor is used for blue LEDs employed as a light source for lighting, backlight and so on, and for LEDs and LDs for multicolor, and the like. Since a bulk monocrystal of the nitride semiconductor is difficult to manufacture, GaN is grown on a substrate made of any of different materials such as sapphire and SiC by means of MOCVD (metal organic chemical vapor deposition). A sapphire substrate is excellent in stability in an ammonia atmosphere during an epitaxial growth process and thus, is especially used as a growing substrate.

To manufacture the nitride semiconductor by means of the MOCVD method, an organometallic compound gas is supplied as a reactant gas into a reaction chamber in which the sapphire substrate is placed as the growing substrate, for example, and a GaN semiconductor crystalline epitaxial layer is grown on the sapphire substrate while a crystal growth temperature is kept high at approximately 900°C to 1100°C.

However, since a lattice constant of the sapphire substrate is largely different from that of the GaN semiconductor crystal, the surface of a GaN semiconductor layer grown directly on the sapphire substrate by means of the MOCVD method has a hexagonal pyramidal or hexagonal columnar growth pattern with an infinite number of irregularities, so that the surface has a very poor morphology. It is extremely difficult to manufacture a device using such semiconductor crystal layer with extremely poor surface morphology having an infinite number of irregularities.

Thus, as described in Patent Document 2 and Patent Document 3, a proposal is made that a low temperature GaN buffer layer formed at a low growth temperature of 500 to 800°C is formed on a growing substrate and a nitride semiconductor crystal is grown thereon. Here, crystal quality and the like of the nitride semiconductor can be expected to improve. Nevertheless, to form the nitride semiconductor crystal after the growth of the low temperature GaN buffer layer, the growth temperature must be increased to a high temperature equal to or above 1000°C after all. This temperature increase process causes a problem that the low temperature GaN buffer layer deteriorates and fails to act as a buffer layer. In addition, the increase of the temperature to a high temperature brings about a problem that the GaN buffer layer previously formed at a low temperature becomes distorted due to heat.

Meanwhile, the low temperature GaN buffer layer having smaller film thickness has the GaN film of better crystal quality because crystal axes of a GaN film crystal-grown on the buffer layer are more likely to be oriented uniformly. However, the buffer layer having the smaller film thickness is more likely to cause the GaN film to have a hexagonal facet formed on the surface thereof, and thus the GaN film has poor surface morphology. Thus, there is a problem in use of manufacturing a device.

On the one hand, it is also proposed that the AIN buffer layer or the like is formed on the sapphire substrate and then, the GaN semiconductor crystal is grown thereon for the purpose of mitigating lattice mismatching between the sapphire substrate and the GaN semiconductor crystal (refer to for example, Patent Document 1).

On the other hand, a light emitting element using the nitride semiconductor has a structure in which, for example, an n-type nitride semiconductor layer (n-type semiconductor layer), an active layer (light emitting layer) and a p-type nitride semiconductor layer (p-type semiconductor layer) are sequentially layered on a substrate. Then, electron holes (holes) supplied from the p-type semiconductor layer and electrons supplied from the n-type semiconductor layer are recombined with each other in the active layer to generate light, and the light is outputted to the outside (refer to, for example, Patent Document 4).

The active layer employs a MQW (Multi-Quantum Well) structure or the like in which each of multiple well layers (well layers) is interposed in a sandwich manner between any two barrier layers (barrier layers) each having a larger band gap than the well layer (refer top, for example, Patent Document 5).

Examples of forming a p-type semiconductor layer in a two-layered structure or three-layered structure to lower a forward voltage (V_{f}) and increase light emitting efficiency are also disclosed (refer to, for example, Patent Document 6 and Patent Document 7).
Patent Document 1: Japanese Patent No. 2713094
Patent Document 2: Japanese Patent No. 3478287
Patent Document 3: Japanese Examined Patent Application Publication No. Hei 8-8217
Patent Document 4: Japanese Patent Application Publication No. Hei 10-284802
Patent Document 5: Japanese Patent Application Publication No. 2004-55719
Patent Document 6: Japanese Patent No. 3250438
Patent Document 7: Japanese Patent No. 3314666

### DISCLOSURE OF THE INVENTION

### PROBLEMS TO BE SOLVED BY THE INVENTION

In the conventional nitride semiconductor light emitting element in which the GaN semiconductor crystal is grown on the AlN buffer layer, an undoped GaN or n-type GaN contact layer is formed on the AlN buffer layer. Here, the lattice constant of AlN is largely different from that of GaN and this lattice mismatching causes lattice failure. Also, having different material compositions, AlN and GaN are largely different from each other in thermal expansion coefficient, thereby easily generating a crack.

Furthermore, when the n-type GaN contact layer is used also as a cladding layer, in addition to the above-mentioned problem of lowering the crystal quality, deterioration in the light emitting efficiency and difficulty in improvement of an light emission output also involve since a large enough band gap difference between the active layer (light emitting layer) and the cladding layer cannot be provided.

Meanwhile, p-type GaN is used as a p-side contact layer in consideration of ohmic contact with an electrode. However, when the p-type GaN contact layer is also used as a cladding layer as well as the above-mentioned n-side semiconductor layer, difficulty in improvement of the light emitting efficiency involves similarly, since a large enough band gap difference between the active layer and the cladding layer cannot be provided.

A p-side cladding layer may be provided separately from the contact layer. However, as being the AlGaN layer, the cladding layer does not lattice-match to the p-type GaN contact layer. This involves problems that crystal quality of the contact layer deteriorates, the carrier injection efficiency lowers, and thus the light emitting efficiency lowers.

Furthermore, when p-type GaN film or the like is formed after the growth of an InGaN active layer, the film is epitaxially grown at the growth temperature around 1000°C which is higher than the growth temperature of the active layer by 200 to 300°C to improve the crystal quality, and the growth time takes about generally 15 to 60 minutes. With such a high growth temperature for the p-type layer, the active layer already formed is damaged due to heat, thereby degrading its crystal quality and greatly decreasing its light emission output.

On the one hand, an approach is proposed as to a method of forming the AlN buffer layer. Since similar problems to those in the low temperature GaN buffer layer occur if the low temperature AlN buffer layer manufactured at the low temperature is used, in this method, a high temperature AlN buffer layer manufactured at a high temperature of 900°C or higher is grown on a growing substrate and then the nitride semiconductor crystal is layered thereon. However, growth conditions for the high temperature AlN buffer layer are strict, and the crystal quality and surface morphology of the nitride semiconductor crystal formed on the AlN buffer layer may deteriorate. Therefore, this method still has a difficulty in manufacturing a high-quality nitride semiconductor crystal.

On the other hand, when formed in a multi-layered structure, the p-type semiconductor layer needs to grow at the low temperature to reduce thermal damage on the active layer, and at the same time, the forward voltage (V_{f}) needs to be lowered and the light emitting efficiency needs to improve.

In the conventional structure, 4 to 5 pairs of MQWs are used. In this case, electrons supplied from the n-type semiconductor layer jump over the active layer and flow up to the p-type semiconductor layer. At this time, the holes supplied from the p-type semiconductor layer recombine with the electrons before reaching the active layer and thus the concentration of the holes reaching the active layer is reduced. As a result, the luminance of the LED decreases. To prevent this, a structure is employed in which a p-type AlGaN layer having a large band gap is interposed between the active layer and the p-type semiconductor layer. However, having aluminum (Al) introduced, the p-type AlGaN layer has difficulty in being p-typed and has its resistance value increased.

A p-type impurity doped into the p-type semiconductor layer disposed on the active layer diffuses from the p-type semiconductor layer to the active layer in a forming process of the p-type semiconductor layer and a subsequent manufacturing process. The p-type impurity which is diffused to the active layer and reaches the well layer causes a problem that the crystal quality of the active layer deteriorates, the luminance of light emitted at the active layer lowers, and thus the quality of the nitride semiconductor light emitting element lowers.

When the active layer is disposed directly on the n-type semiconductor layer, a phenomenon may occur that the electrons supplied from the n-type semiconductor layer to the active layer reach the p-type semiconductor layer placed immediately above the active layer and recombine with the holes in the p-type semiconductor layer (hereinafter this phenomenon is referred to as "electron overflow"). This has a problem that the luminance of light emitted from the semiconductor light emitting element lowers and the quality of the semiconductor light emitting element also lowers since light emission by the recombination in the p-type semiconductor layer is poor in efficiency. In addition, a problem also arises in the manufacturing process of the semiconductor light emitting element, that an n-type impurity added to the n-type semiconductor layer diffuses to the active layer, the crystal quality of the active layer is degraded, and thus the luminance of the light emission output lowers.

Conventionally, in forming the p-type semiconductor layer to which the p-type impurity is added, a carrier gas containing hydrogen (H₂) and nitrogen (N₂) is used as a source gas supply. However, when the p-type semiconductor layer is formed by using the carrier gas containing hydrogen, hydrogen atoms taken in along with the p-type impurity makes it difficult to activate the p-type impurity and inhibits the p-type semiconductor layer to be p-typed so that the crystal quality of the p-type semiconductor layer is degraded. For this reason, after formation of the p-type semiconductor layer, it is need to perform annealing to remove the hydrogen atoms from the p-type semiconductor layer, leading to an increase in the number of manufacturing steps.

The present invention is devised to solve the above-mentioned problems and the object of the present invention is to provide a nitride semiconductor light emitting element having improved light emission output and with improved qualities, such as crystal qualities, of a nitride semiconductor layered on an AlN buffer layer, and also to provide a method for manufacturing a nitride semiconductor.

### MEANS FOR SOLVING THE PROBLEMS

To achieve the above object, an aspect of the present invention provides a nitride semiconductor light emitting element in which an n-type AlGaN cladding layer is formed on an AlN buffer layer.

Another aspect of the present invention provides a nitride semiconductor light emitting element in which, an n-type AlGaN cladding layer is formed on the AlN buffer layer and an active layer having the quantum well structure is formed on the n-type AlGaN cladding layer, and the active layer is formed of an Al_{X1}In_{Y1}Ga_{Z1}N well layer (X1 + Y1 + Z1 = 1, 0 < X1 < 1, 0 < Y1 < 1, 0 < Z1 < 1) and an Al_{X2}Ga_{Y2}N barrier layer (X2 + Y2 = 1, 0 < X2 < 1, 0 <Y2<1).

Another aspect of the present invention provides a nitride semiconductor light emitting element in which an n-type AlGaN cladding layer is formed on an AlN buffer layer, an active layer having a quantum well structure is formed on the n-type AlGaN cladding layer, a p-type AlInGaN cladding layer or a p-type AlInGaN/InGaN superlattice cladding layer is formed on the active layer, and the active layer is formed of an Al_{X1}In_{Y1}Ga_{Z1}N well layer (X1 + Y1 + Z1 = 1, 0 < X1 < 1, 0 < Y1 < 1, 0 < Z1 < 1) and an Al_{X2}Ga_{Y2}N barrier layer (X2 + Y2 = 1, 0 < X2 < 1, 0 < Y2 < 1).

Another aspect of the present invention provides a nitride semiconductor light emitting element which include: a substrate; an AlN buffer layer disposed on the substrate; an n-type semiconductor layer which is disposed on the AlN buffer layer and is doped with an n-type impurity; a block layer which is disposed on the n-type semiconductor layer and is doped with the n-type impurity at a lower concentration than that of the n-type semiconductor layer; an active layer which is disposed on the block layer, has a layered structure obtained by alternately disposing a barrier layer and a well layer having a smaller band gap than the barrier layer, and is formed of a multi quantum well containing indium; a first nitride semiconductor layer which is disposed on the active layer and contains a p-type impurity; a second nitride semiconductor layer which is disposed on the first nitride semiconductor layer and contains a p-type impurity at a lower concentration than the p-type impurity in the first nitride semiconductor layer; a third nitride semiconductor layer which is disposed on the second nitride semiconductor layer and contains a p-type impurity at a higher concentration than the p-type impurity in the second nitride semiconductor layer; and a fourth nitride semiconductor layer which is disposed on the third nitride semiconductor layer and contains a p-type impurity at a lower concentration than the p-type impurity in the third nitride semiconductor layer, and in which the film thickness of a last barrier layer which is the topmost layer in the layered structure is larger than a diffusion distance of the p-type impurity in the first nitride semiconductor layer.

Another aspect of the present invention provides a nitride semiconductor light emitting element which include: a substrate; an AlN buffer layer disposed on the substrate; an n-type semiconductor layer which is disposed on the AlN buffer layer and is doped with an n-type impurity; a block layer which is disposed on the n-type semiconductor layer and is doped with the n-type impurity at a lower concentration than that of the n-type semiconductor layer; an active layer which is disposed on the block layer, has a layered structure obtained by alternately disposing a barrier layer and a well layer having a smaller band gap than the barrier layer, and is formed of a multi quantum well containing indium; a first nitride semiconductor layer which is disposed on the active layer and contains a p-type impurity; a second nitride semiconductor layer which is disposed on the first nitride semiconductor layer and contains a p-type impurity at a lower concentration than the p-type impurity in the first nitride semiconductor layer; and a transparent electrode which is disposed on the second nitride semiconductor layer and is formed of an oxide electrode, and in which the film thickness of a last barrier layer which is the topmost layer in the layered structure is larger than a diffusion distance of the p-type impurity in the first nitride semiconductor layer.

Another aspect of the present invention provides a method for manufacturing a nitride semiconductor in which a nitride semiconductor crystal is grown on an AlN buffer layer and the AlN buffer layer by alternately supplying an Al material and an N material at the growth temperature of 900°C or higher.

### EFFECTS OF THE INVENTION

In to the present invention, the n-side cladding layer is formed of the n-type AlGaN layer crystal-grown on the AlN buffer layer and the p-side cladding layer is formed of a p-type AlInGaN layer or a p-type AlInGaN/InGaN superlattice layer. Accordingly, as to the n-side cladding layer, the AlN buffer layer and the n-side cladding layer lattice-match better so that the n-side cladding layer having high crystal quality with less lattice failure than the conventional one can be obtained. Since AlN and AlGaN is similar to each other in composition material as well as in thermal extension coefficient, distortion due to heat can be reduced.

In addition, the n-side cladding layer made of AlGaN by adding Al to GaN makes the band gap widened. Accordingly, the band gap difference between the n-side cladding layer and the active layer can be made large and thus the effect of confining light and carriers can be improved, thereby improving the light emitting efficiency.

Meanwhile, adding Al to the well layer of the active layer increases crystal connectivity and improves the heat resistance property. This can reduce damage on the p-type layer due to heat at crystal growth and thus can prevent lowering of the light emitting efficiency in especially green to yellow areas where In composition ratio is high. Furthermore, the addition of Al also to the barrier layer (barrier layer) of the active layer can make the band gap widened. This improves the effect of confining carriers, thereby improving the light emission output.

On the other hand, the p-side cladding layer serves as an electron blocking layer to prevent electrons from flowing from the active layer into the p-side cladding layer, thereby improving the light emitting efficiency. Also, as being p-type AlInGaN by adding In to p-type AlGaN, the p-side cladding layer is more likely to lattice-match to the p-side contact layer so that the crystal quality of the p-side contact layer is improved. At the same time, since the carrier concentration increases and the hole injection efficiency is improved, the light emitting efficiency is improved.

According to the present invention, the p-type semiconductor layer can be formed at the low temperature to reduce thermal damage on the active layer, lower the forward voltage V_{f}, and improve the light emitting efficiency.

According to the present invention, the number of MQW pairs of the active layer can be optimized, the MQW pairs provided for effectively recombining the electrons supplied from the n-type semiconductor layer with the holes supplied from the p-type semiconductor layer in the active layer. This improves the light emitting efficiency.

According to the present invention, it is possible to prevent the p-type impurity from diffusing from the p-type semiconductor layer to the well layer, thereby improving the light emitting efficiency.

According to the present invention, it is possible to suppress electron overflow from the n-type semiconductor layer to the p-type semiconductor layer and diffusion of the n-type impurity from the n-type semiconductor layer to the active layer, thereby improving the light emitting efficiency.

The present invention can provide the semiconductor light emitting element which does not require the annealing process of removing hydrogen atoms from the p-type semiconductor layer.

The present invention can provide the semiconductor light emitting element with improved external light emitting efficiency with the use of the effective lamination film.

In the present invention, an Al (aluminum) material and an N (nitrogen) material for the AlN buffer layer manufactured at the growth temperature of 900°C or higher are alternately supplied. Accordingly, the molar ratio of N material/Al material is an appropriate value and Al is not taken into the nitride semiconductor crystal. As a result, it is possible to form the nitride semiconductor crystal having good crystal quality and surface morphology.

Further, the AlN buffer layer is manufactured at a high temperature of 900°C or higher. The temperature has almost no difference with the growth temperature of the nitride semiconductor crystal layered on the buffer layer and thus, the nitride semiconductor crystal can start growing in no time. Therefore, deterioration of the AlN buffer layer due to heat can be prevented. This can also prevent thermal distortion of the AlN buffer layer which which otherwise may occur due to a difference in growth temperature.

Furthermore, since the manufacturing time can be greatly reduced as compared to that according to the conventional method of manufacturing the AlN buffer layer, the manufacturing time of the whole nitride semiconductor can be also shortened.

### BRIEF DESCRIPTION OF DRAWINGS

[Fig. 1] Fig. 1 is a diagram showing an example of a sectional structure of a nitride nitride semiconductor light emitting element according to the present invention.
[Fig. 2] Fig. 2 is a diagram showing an example of another structure of the nitride nitride semiconductor light emitting element according to the present invention.
[Fig. 3] Fig. 3 is a diagram showing an example of still another structure of the nitride semiconductor light emitting element according to the present invention.
[Fig. 4] Fig. 4 is a diagram showing an example of still another structure of the nitride semiconductor light emitting element according to the present invention.
[Fig. 5] Fig. 5 is a diagram showing a sectional structure in the case where a p-type GaN layer has a four-layered multi-layered structure.
[Fig. 6] Fig. 6 is a diagram showing an example of another structure of the nitride semiconductor light emitting element according to the present invention.
[Fig. 7] Fig. 7 is a diagram showing a multi quantum well structure of an active layer in the nitride semiconductor light emitting element according to the present invention.
[Fig. 8] Fig. 8 is a graph showing a gas flow pattern in crystal growth on the active layer.
[Fig. 9] Fig. 9 is a graph showing an effect of a thermal processing temperature on the active layer for each type of the active layer.
[Fig. 10] Fig. 10 is a graph showing change in blackening of the active layer due to an Al addition ratio to the active layer and a thermal processing temperature thereon.
[Fig. 11] Fig. 11 is a chart showing a method for forming the AlN buffer layer in a method for forming the nitride semiconductor according to the present invention.
[Fig. 12] Fig. 12 is a diagram showing the overall structure of the nitride semiconductor including the AlN buffer layer.
[Fig. 13] Fig. 13 is a diagram showing an example of the specific structure of the nitride semiconductor crystal shown in Fig. 12.
[Fig. 14] Fig. 14 is a chart showing a conventional method for forming the AlN buffer layer.
[Fig. 15] Fig. 15 is a view showing the surface of the AlN buffer layer manufactured according to the conventional method.
[Fig. 16] Fig. 16 is a view showing the surface of GaN layered on the AlN buffer layer manufactured according to the conventional method.
[Fig. 17] Fig. 17 is a view showing an internal state of the GaN crystal shown in Fig. 16.
[Fig. 18] Fig. 18 is a schematic sectional structural diagram of a first nitride semiconductor light emitting element according to the present invention, (a) is a schematic sectional structural diagram of the nitride semiconductor light emitting element and (b) is a schematic enlarged sectional structural diagram of a part of the active layer.
[Fig. 19] Fig. 19 is a schematic sectional structural diagram based on a modification example of the first nitride semiconductor light emitting element according to the present invention, (a) is a schematic sectional structural diagram of the nitride semiconductor light emitting element and (b) is a schematic enlarged sectional structural diagram of a part of the active layer.
[Fig. 20] Fig. 20 is a schematic sectional structural diagram of the first nitride semiconductor light emitting element according to the present invention including a p-side electrode and an n-side electrode formed therein.
[Fig. 21] Fig. 21 is a graph showing relationship between a light emission output and the number of pairs of quantum well in the nitride semiconductor light emitting element according to the present invention.
[Fig. 22] Fig. 22 is a schematic diagram of a band structure for illustrating a light emission phenomenon in a MQW layer in the nitride semiconductor light emitting element according to the present invention.
[Fig. 23] Fig. 23 shows a band structure for illustrating a light emission phenomenon in a MQW layer in the nitride semiconductor light emitting element according to the present invention, (a) is a schematic diagram of a band structure having five pairs of MQW layers, (b) is a schematic diagram of a band structure having eight pairs of MQW layers and (c) is a schematic diagram of a band structure having 12 pairs of MQW layers.
[Fig. 24] Fig. 24 is a graph for illustrating a temperature distribution (a) and hydrogen gas flow conditions (b) to (e) in the case where four-layered p-type semiconductor layers (341 to 344) are formed in the nitride semiconductor light emitting element according to the present invention.
[Fig. 25] Fig. 25 is a graph for illustrating a temperature distribution (a), a nitrogen gas flow condition and a ammonia gas flow condition (c) in the case where four-layered p-type semiconductor layers (341 to 344) are formed in the nitride semiconductor light emitting element according to the present invention.
[Fig. 26] Fig. 26 is a schematic sectional structural diagram of the nitride semiconductor light emitting element according to the present invention after a process of forming a last electrode.

### DESCRIPTION OF REFERENCE NUMERALS

- 1: Sapphire Substrate
- 2: AlN Buffer Layer
- 3: n-Type AlGaN Layer
- 4: InGaN/GaN Active Layer
- 5: p-type AlGaN Layer
- 6: p-Type GaN Layer
- 7: p Electrode
- 8: n Electrode
- 31: Substrate
- 32: n-Type Semiconductor Layer
- 33: Active Layer
- 34: p-Type Semiconductor Layer
- 35: Oxide Electrode
- 36: Buffer Layer
- 37: Block Layer
- 38: Reflective Lamination Film
- 331: Barrier Layer (GaN Layer)
- 332: Well Layer (InGaN Layer)
- 341: First Nitride Semiconductor Layer
- 342: Second Nitride Semiconductor Layer
- 343: Third Nitride Semiconductor Layer
- 344: Fourth Nitride Semiconductor Layer
- 40: p-Side Electrode
- 200, 300: n-Side Electrode
- 3310: Last Barrier Layer
- 3311 To 331n: Barrier Layer
- 3321 To 332n: Well Layer

### BEST MODE FOR CARRYING OUT THE INVENTION

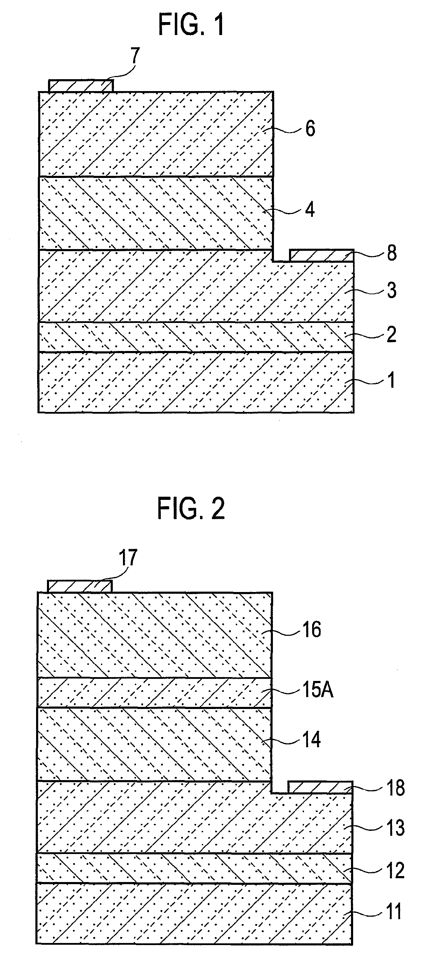

An embodiment of the present invention will be described hereinbelow with reference to drawings. Fig. 1 shows an example of a structure of a nitride semiconductor light emitting element according to the present invention.

A sapphire substrate 1 is used as a growing substrate, and an AlN buffer layer 2 is formed on the sapphire substrate 1. On the AlN buffer layer 2, nitride semiconductors of an n-type AlGaN layer 3, an InGaN/GaN active layer 4, and a p-type GaN layer 6 are layered in this order. These nitride semiconductors are formed by the known MOCVD method or the like. The nitride semiconductor here indicates an AlGaInN quaternary mix crystal, which is so called a III-V nitride semiconductor, and can be expressed as AlₓGa_{y}In_{z}N (x + y + z = 1, 0 ≤ x ≤ 1, 0 ≤ y ≤ 1, 0 ≤ z ≤ 1).

Further, mesa etching is performed from the p-type GaN layer 6 until the n-type AlGaN layer 3 is exposed and an n electrode 8 is formed on the surface of the exposed n-type AlGaN layer 3. Meanwhile, a p electrode 7 is formed on the p-type GaN layer 6. Each of the p electrode 7 and the n electrode 8 employs a metallic multilayer film structure such as Ti/Au or Al/Ti/Au.

The n-type AlGaN layer 3 serves both as a cladding layer for confining light and carriers and as a contact layer for ohmic contact with the n electrode 8. The n-type AlGaN layer 3 is formed of AlxGaN doped with an n-type impurity Si (silicon) at a concentration in the range of 1 × 10¹⁸ cm⁻³ to 5 × 10¹⁸ cm⁻³, for example, on the order of 3 × 10¹⁸ cm⁻³. Here, a composition ratio X of Al can be set to fall within the range of 0.01% to 20%, for example, 3%. When the Al composition ratio X exceeds 20%, the crystal quality ofAlGaN degrades. Therefore, it is desirable that the composition ratio is 20% at a maximum as described above.

On the other hand, the p-type GaN layer 6 also serves both as a cladding layer for confining light and carriers and as a contact layer for ohmic contact with the p electrode 7. The p-type GaN layer 6 is doped with, for example, p-type impurity Mg at a concentration in the range of 3 × 10¹⁹ cm⁻³.

The active layer 4 is an active layer having a quantum well structure (Quantum Well) in which a well layer (well layer) is interposed in a sandwich manner between barrier layers (barrier layers) each having a larger band gap than the well layer. This quantum well structure is not limited to one, and may be multiplexed to form MQW (Multi Quantum Well), that is, a multi quantum well structure.

The InGaN/GaN active layer 4 is formed of a multi quantum well structure (MQW) obtained by alternately stacking an undoped InGaN well layer having a film thickness of 28 Å and an undoped GaN barrier layer having a film thickness of 165 Å in eight cycles, for example.

Here, an n-side cladding layer is formed of the n-type AlGaN layer 3 which is crystal-grown on the AlN buffer layer 2. Since lattice matching between AlN and AlGaN is better than lattice matching between AlN and GaN, the n-side cladding layer with less lattice failure and better crystal quality than the conventional one can be obtained. Since AlN and AlGaN is similar to each other in composition material as well as in thermal extension coefficient, distortion due to heat can be reduced.

In addition, the n-side cladding layer made of AlGaN by adding Al to GaN makes the band gap widened. Accordingly, the band gap difference between the n-side cladding layer and the InGaN/GaN active layer 4 can be made large and thus the effect of confining light and carriers (cladding effect and barrier effect) can be improved, thereby improving the light emission output.

A method for manufacturing the nitride semiconductor element in Fig. 1 will be described. First, the sapphire substrate 1 is placed in a MOCVD (Metallic Organic Chemical Vapor Deposition) device and a hydrogen gas is caused to flow thereinto while the temperature is raised to about 1050°C to thermally clean the sapphire substrate 1. The temperature is kept as it is or lowered to a proper temperature of not less than 900°C to grow a high temperature AlN buffer layer 2. The growth temperature of the high temperature AlN buffer layer 2 needs to be 900°C or higher. For example, trimethyl aluminum (TMA) as a source gas for Al and ammonia (NH₃) as a source gas for N (nitrogen) are supplied to a reaction chamber to manufacture the high temperature AlN buffer layer.

Next, the growth temperature is raised to 1020°C to 1040°C, 20 µ moles of trimethylgallium (TMGa) per minute is supplied, for example, in addition to the supply of TMA, and silane (SiH₄) is supplied as an n-type dopant gas to grow the n-type AlGaN layer 3. Subsequently, the supply of TMA, TMGa, silane is stopped, the substrate temperature is lowered to fall within 700°C to 800°C in a mixed atmosphere of ammonia and hydrogen, 200 µ moles of trimethylindium (TMIn) per minute and 20 µ moles of triethylgallium (TEGa) per minute are supplied, the undoped InGaN well layer of the InGaN/GaN active layer 4 is layered, the supply of only TMIn is stopped, and the barrier layer made of undoped GaN is layered. Then, the GaN barrier layer and the InGaN well layer are repeatedly layered to form the multi quantum well structure.

After the growth of the InGaN/GaN active layer 4, the supply of TMIn is stopped, the growth temperature is raised to about 850°C, and trimethylgallium (TMGa) as a source gas for Ga atoms, ammonia (NH₃) as a source gas for nitrogen atoms and CP₂Mg (biscyclopentadiethyl magnesium) as a dopant material for the p-type impurity Mg are supplied to grow the p-type GaN layer 6.

In manufacturing of each semiconductor layer, along with hydrogen and nitrogen of the carrier gas, necessary gases are supplied including reactant gases corresponding to the component of each of the semiconductor layers, such as triethylgallium (TEGa), trimethylgallium (TMG), ammonia (NH₃), trimethyl aluminum (TMA), trimethylindium (TMIn), silane (SiH₄) as a dopant gas for making the semiconductor layer n-typed, and CP₂Mg (cyclopentadienyl magnesium) as a dopant gas for making the semiconductor layer p-typed. Accordingly, the semiconductor layers are sequentially grown in the range of about 700°C to 1200°C, so that a desired conductive type semiconductor layer with desired composition can be formed to have a required thickness.

As described above, if the AlN buffer layer 2 is the high temperature AlN buffer layer grown at the growth temperature of 900°C or higher, the growth temperature has only a small difference with the growth temperature of the n-type AlGaN layer 3. Thus, it is possible to prevent deterioration of the AlN buffer layer 2 due to the temperature raise at the growth of the n-type AlGaN layer 3 and reproducibility is improved. It is also possible to prevent thermal distortion of the AlN buffer layer 2 which otherwise may occur due to difference in growth temperature.

Meanwhile, the AlN buffer layer 2 may be manufactured on the growing substrate as a low temperature AlN buffer layer having a film thickness of 100 to 500 Å (Angstrom) at the low growth temperature of 400 to 800°C. However, growth conditions of the buffer layer are strictly limited and the film thickness needs to be precisely set thin in the range of 100 to 500 Å. This makes it difficult to improve the crystal quality and surface morphology of the semiconductor with good yields. Meanwhile, the low temperature AlN buffer layer having smaller film thickness has the GaN film of better crystal quality because crystal axes of a GaN film crystal-grown on the buffer layer are more likely to be oriented uniformly. However, the buffer layer having the smaller film thickness is more likely to cause the GaN film to have a hexagonal facet formed on the surface thereof, and thus the GaN film has poor surface morphology..

The growth film thicknesses of the high temperature AlN buffer layer 2, the n-type AlGaN layer 3, the InGaN/GaN active layer 4, and the p-type GaN layer 6 can be made, for example, 10 Å to 50 Å, about 4 µm, about 0.1 µm and about 0.2 µm, respectively. Since it is sufficient for the high temperature AlN buffer layer 2 to have very thin in thickness as described above, manufacturing time can be reduced.

As described above, after stacking up to the p-type GaN layer 6, a part of the n-type AlGaN layer 3 is exposed by mesa etching and the n electrode 8 is formed on the exposed surface. On the other hand, the p electrode 7 is formed on the p-type GaN layer 6.

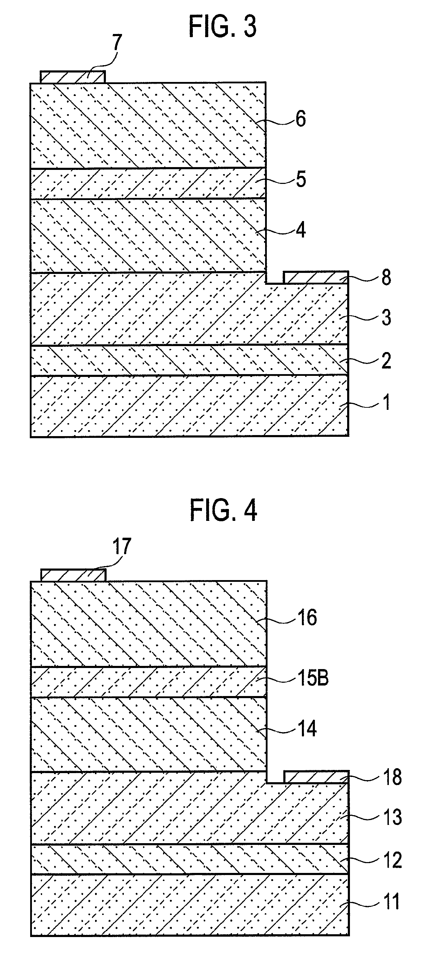

Next, Fig. 2 to Fig. 4 show the other examples of a structure of the nitride semiconductor light emitting element according to the present invention. Fig. 1 and Fig. 3 show examples of a structure each employing the InGaN/GaN active layer 4. The structure in Fig. 1 is different from the structure in Fig. 3 in that a p-type AlInGaN layer 5 is added in Fig. 3. On the other hand, Fig. 2 and Fig. 4 show examples of the structure each employing an AlInGaN/AlGaN active layer 14. These structures are different in that a p-type AlInGaN layer 15A is used as the p-type cladding layer in the structure in Fig. 2 while a p-type AlInGaN/InGaN superlattice layer 15B is used as the p-type cladding layer in the structure in Fig. 4.

Here, the description is given based on Fig. 2. An AlN buffer layer 12 is formed on a sapphire substrate 11, and nitride semiconductor layers of an n-type AlGaN layer 13, an AlInGaN/AlGaN active layer 14, a p-type AlInGaN layer 15A, and a p-type GaN layer 16 are layered on the AlN buffer layer 12 in this order. In addition, a p electrode 17 is formed on the p-type GaN layer 16 and an n electrode 18 is formed on the n-type AlGaN layer 13 exposed by mesa etching.

Structures and the like of the sapphire substrate 11, the AlN buffer layer 12, and the n-type AlGaN layer 13 are the same as those in Fig. 1. The layer structure is different from that in Fig. 1 in that the p-type AlInGaN layer 15A is newly added. The p-type AlInGaN layer 15A is a p-side cladding layer and serves as the electron blocking layer. As described above, unlike the structure in Fig. 1, the p-side is divided into the p-type AlInGaN layer 15A as the cladding layer and the p-type GaN layer 16 as the contact layer.

Moreover, Al is added to an active layer 14 and to the p-side cladding layer in order to reduce the difference in lattice constant in the layered structure formed of the n-type AlGaN layer 13, the AlInGaN/AlGaN active layer 14, and the p-type AlInGaN layer 15A. The structure of the n-type AlGaN layer 13 is the same as that of the above-mentioned n-type AlGaN layer 3. The p-type AlInGaN layer 15A is made of Al_{X3}In_{Y3}Ga_{Z3}N (X3 + Y3 + Z3 = 1, 0 < X3 < 1, 0 < Y3 < 1, 0 < Z3 < 1). The Al composition ratio X3 is desirably set to fall within the range of 0.01% to 20%, since crystal quality is degraded if the Al composition ratio X3 exceeds 20%.

Alternatively, the p-type AlInGaN layer 15A may be replaced with the p-type AlInGaN/InGaN superlattice layer 15B as shown in Fig. 4. In the case of Fig. 4, the p-type AlInGaN/InGaN superlattice layer 15B is formed of a layered body obtained by alternately stacking Al_{X4}In_{Y4}Ga_{Z4}N (X4 + Y4 + Z4 = 1, 0 < X4 < 1, 0 < Y4 < 1, 0 < Z4 < 1) and In_{X5}Ga_{Y6}N (X5 + Y5 = 1, 0 < X5 < 1, 0 < Y5 < 1). The Al composition ratio X4 of Al_{X4}In_{Y4}Ga_{Z4}N is set to fall within the range of 0.01% to 20%, since crystal quality is degraded if the Al composition ratio X4 exceeds 20%. The In composition ratio Y4 is set to be 0 < Y4 < 0.1, while the In composition ratio Y5 of In_{X5}Ga_{Y6}N is set to be 0 < Y5 < 0.1.

Here, in the structure shown in Fig. 3, the InGaN/GaN active layer 4 is used as in Fig. 1 without adding Al to the active layer, the p-side is divided into the p-type AlInGaN layer 5 as the cladding layer and the p-type GaN layer 6 as the contact layer.

Since the structure in Fig. 3 includes the n-side and p-side cladding layers as described above, the following effects are obtained. The n-side cladding layer is formed of the n-type AlGaN layer 3 crystal-grown on the AlN buffer layer 2. Since lattice matching between the AlN and AlGaN is better than lattice matching between AlN and GaN, the n-side cladding layer with less lattice failure and better crystal quality than the conventional one can be obtained. Furthermore, since AlN and AlGaN is similar to each other in composition material as well as in thermal extension coefficient, distortion due to heat can be reduced.

On the other hand, the p-side cladding layer is formed of any of the p-type AlInGaN layer and the p-type AlInGaN/InGaN superlattice layer. Each of these semiconductor layers serves as the electron blocking layer which prevents electrons from flowing from the active layer to the p-side cladding layer so that the light emitting efficiency is improved. Furthermore, as including at least the p-type AlInGaN by adding In to p-type AlGaN, the p-side cladding layer is more likely to lattice-match to the p-side contact layer of each of p-type GaN layers 6, 16 so that the crystal quality of each of the p-type GaN contact layers 6, 16 is improved. At the same time, since the carrier concentration increases and the hole injection efficiency is improved, the light emitting efficiency is improved.

In the case where the InGaN/GaN active layer without Al is used as in Fig. 1 and Fig. 3 instead of the active layer 14, the following problems occur. In forming the p-type GaN layer or the like after the growth of the InGaN/GaN active layer 4, the layer is epitaxially grown at the growth temperature around 1000°C which is higher than the conventional growth temperature of the active layer by 200 to 300°C to improve the crystal quality, and the growth time takes about generally 15 to 60 minutes. With such a high growth temperature for the p-type layer, the active layer 4 already formed is damaged due to heat, thereby greatly deteriorating light emitting characteristics.

Especially when the nitride semiconductor light emitting element having a long light emitting wavelength in green to yellow regions is manufactured, the higher grow temperature is required as the In composition ratio of the well layer exceeding 20% is higher. As the In composition ratio is higher, In is more likely to sublime and break down when the nitride semiconductor light emitting element is placed in the high temperature state, resulting in extremely poor light emitting efficiency. When the nitride semiconductor light emitting element is continuously damaged due to heat, In is separated and a wafer may be blackened. As a solution for such a problem, Al is added to the whole of the active layer 14 to improve the heat resistance property Further, by setting the growth temperature of the p-type GaN layer 16 to about 850°C, not a high temperature around 1000°C, deterioration of the active layer can be further prevented.

The AlInGaN/AlGaN active layer 14 is formed of a quaternary mixed crystal AlInGaN by adding Al to the whole of the active layer, and has a multi quantum well structure formed of an AI_{X1}In_{Y1}Ga_{Z1}N well layer (X1 + Y1 + Z1 = 1, 0 < X1 < 1, 0 < Y1 < 1, 0 < Z 1 < 1) as the well layer and an Al_{X2}Ga_{Y2}N barrier layer (X2 + Y2 = 1, 0 < X2 < 1, 0 < Y2 < 1) as the barrier layer. An Al composition ratio X1 of the well layer can be set to 0.01% to 6% and an Al composition ratio X2 of the barrier layer can be set to 0.01% to 20% since the crystal quality is degraded if the Al composition ratio exceeds 20%.

Here, as an example, the barrier layer is formed of Al_{0.005}GaN which is undoped or doped with Si at the doping concentration of 5 × 10¹⁶cm⁻³ to less than 1 × 10¹⁷cm⁻³ and has a film thickness of 70 to 170 Å. Meanwhile, the well layer is formed of, for example, undoped Al_{0.005}InGaN having a film thickness of 28 Å, and the well layer and the barrier layer are alternately layered in about eight cycles. As described above, by adding Al to the well layer of the active layer 4, the heat-resistant active layer 14 is formed. Furthermore, by adding Al to the barrier layer of the active layer 4, the band gap can be widened, thereby improving the effect of confining carriers and increasing the light output.

In the case where the p-type AlInGaN/InGaN superlattice layer 15B is employed as the p-type cladding layer as shown in Fig. 4, the crystal quality of the superlattice layer 15B is improved since AlInGaN/AlGaN active layer 14 and the p-type AlInGaN/InGaN superlattice layer 15B lattice-match well.

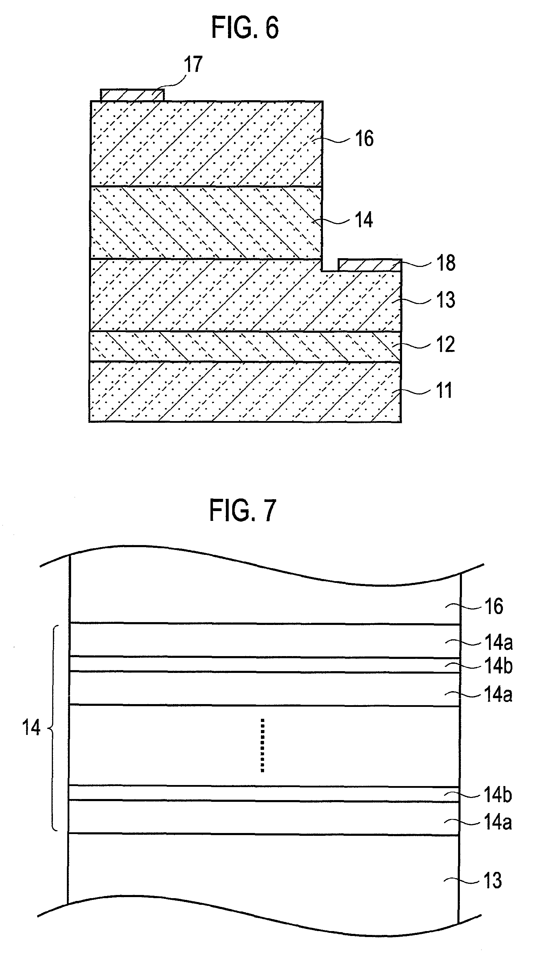

Next, the above-mentioned heat-resistant AlInGaN/AlGaN active layer 14 will be described below in detail. Fig. 6 shows an example of a structure of the nitride semiconductor light emitting element employing the AlInGaN/AlGaN active layer 14. This structure is obtained by excluding the p-type AlInGaN layer 15A or the p-type AlInGaN/InGaN superlattice layer 15B from the structure shown in Fig. 2 or Fig. 4. The same reference numerals as those in Fig. 2 and Fig. 4 are given to express the same components.

For the above reason, the p-type GaN layer 16 serves both as the cladding layer for confining light and carriers and as the contact layer for ohmic contact with the p electrode 17. The p-type GaN layer 16 is doped with, for example, the p-type impurity Mg at a concentration of about 3 × 10¹⁹ cm⁻³.

Fig. 7 shows a structure of the active layer 14 in detail. A barrier layer 14a is disposed on the side of the active layer 14 to come into contact with the n-type AlGaN layer 13 and a well layer 14b is layered thereon. After the barrier layer 14a and the well layer 14b are alternately layered in some cycles, the last barrier layer 14a is formed. The p-type GaN layer 16 is layered on the last barrier layer 14a.

The AlInGaN/AlGaN active layer 14 has the multi quantum well structure (MQW) obtained by alternately stacking, for example, an Al_{X1}In_{Y1}Ga_{Z1}N well layer (X1 + Y1 + Z1 = 1, 0 < X1 < 1, 0 < Y1 < 1, 0 < Z1 < 1) having a film thickness of 28 Å and an Al_{X2}Ga_{Y2}N barrier layer (X2 + Y2 = 1, 0 < X2 < 1, 0 < Y2 < 1) having a film thickness of 165 Å in eight cycles.

Here, as an example, the barrier layer 14a is formed of Al_{0.005}GaN which is undoped or doped with Si at the doping concentration of 5 × 10¹⁶ cm⁻³ to less than 1 × 10¹⁷ cm⁻³ and has a film thickness of 70 to 170 Å. Meanwhile, the well layer 14b is formed of, for example, undoped Al_{0.005}InGaN having a film thickness of 28 Å, and the well layer and the barrier layer are alternately layered in about eight cycles. As described above, by adding Al to the well layer of the active layer 14, the heat-resistant active layer 14 is formed. Furthermore, by adding Al to the barrier layer of the active layer 14, the band gap can be widened, thereby improving the effect of confining carriers and increasing the light output.

With this addition of Al, the In composition must be somewhat larger than the In composition ratio of the InGaN well layer with a conventional structure to obtain a desired wavelength. This increase of In composition enhances the piezo effect. However, the piezo effect can be reduced by doping the active layer 14 with Si of the n-type impurity as described above.

In the nitride semiconductor light emitting element shown in Fig. 6, after the AlN buffer layer 12 is formed on the sapphire substrate 11, an AlInGaN/AlGaN superlattice layer is formed in place of the n-type AlGaN layer 13, and the AlInGaN well layer and the AlGaN barrier layer are formed in five cycles to serve as the active layer 14. Then, annealing processing is performed to assess whether or not the surface of the active layer 14 is blackened depending on the annealing temperature (thermal processing temperature) and the composition ratio of Al. The composition ratio of Al in the AlInGaN well layer is the same as the composition ratio of Al in the AlGaN barrier layer.

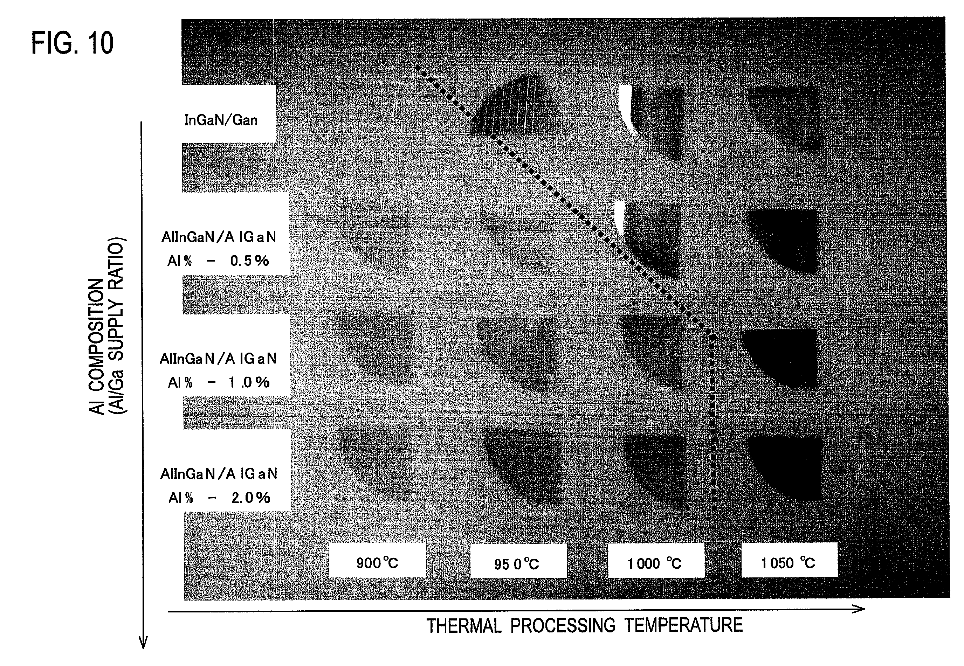

Fig. 10 shows a part of experiment data, and image data of the surface of the active layer 14 is shown in coordinates with the vertical axis representing the Al composition (Al/Ga supply ratio) and the horizontal axis representing the thermal processing temperature (annealing temperature). In the active layer 14, undoped AlGaN is alternately layered to be used as the barrier layer (barrier layer) and the In composition ratio of the AlInGaN well layer is set to about 20%. Thermal processing at each temperature is performed in a nitrogen atmosphere and a thermal processing time is set to 30 minutes.

For comparison with the active layer to which Al is added, a structure is also assessed which employs a conventional InGaN/GaN active layer instead of the active layer 14, and an InGaN/GaN superlattice layer instead of the above-mentioned AlInGaN/AlGaN superlattice layer. This structure is subjected to thermal processing in the same conditions. The In composition ratio of the InGaN well layer is set to about 20% as in the above case. A broken line in Fig. 10 represents a boundary line at which blackening of the wafer starts.

As apparent from Fig. 10, in the conventional InGaN/GaN active layer, blackening of the wafer appears at 950°C. However, in the AlInGaN/AlGaN active layer having the Al composition of 0.5%, blackening starts by thermal processing at 1000°C. When the Al composition is increased to 1.0%, blackening starts only after the thermal processing temperature of 1050°C and the active layer has no problem even at 1000°C. When the Al composition is increased to 2.0%, the state remains the same as the state in the case of the Al composition of 1.0% and the heat resistance property is not improved so much.

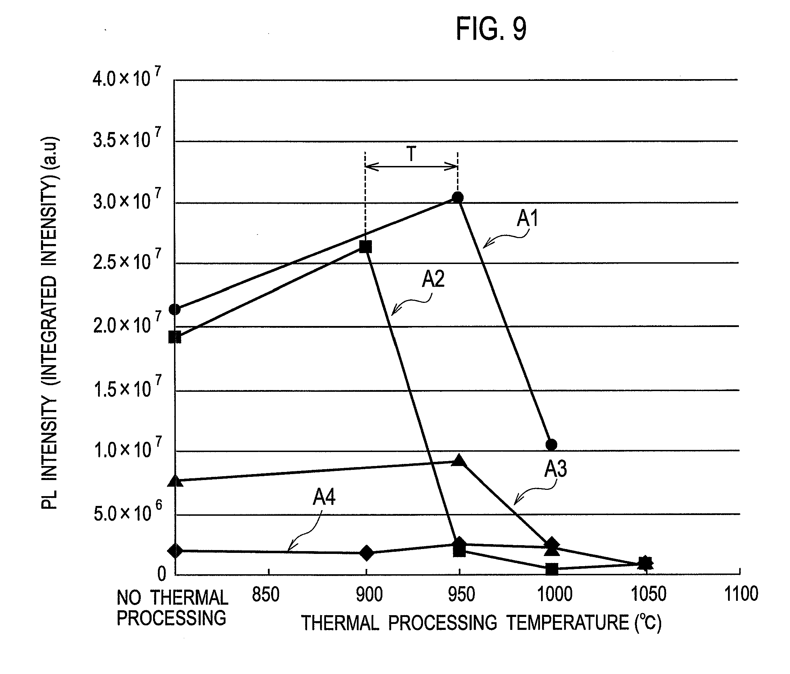

Next, Fig. 9 shows results of PL (photoluminescence) measurement. A vertical axis represents PL intensity (arbitrary unit) and a horizontal axis represents the thermal processing temperature. First, as in the case shown in Fig. 10, with the structure shown in Fig. 6, the AlInGaN well layer and the AlGaN barrier layer or the AlInGaN well layer and the GaN barrier layer are formed on the sapphire substrate 11 in about five cycles to serve as the active layer 14. Then, the annealing temperature is changed and thermal processing (30 minutes) is performed in the nitrogen atmosphere. Thereafter, light emitting spectrum (PL intensity distribution) is measured at the room temperature and an integral value of the PL intensity distribution at each temperature is found.

A curve A1 represents the case where the active layer has the MQW structure of the AlInGaN well layer/AlGaN barrier layer having the Al composition ratio of 0.25%. A curve A2 represents the case where the active layer has the conventional structure, that is, a MQW structure of the InGaN well layer/GaN barrier layer. A curve A3 represents the case where the active layer has the MQW structure of the AlInGaN well layer/GaN barrier layer having the Al composition ratio of 1%. A curve A4 represents the case where the active layer has the MQW structure of the AlInGaN well layer/AlGaN barrier layer having the Al composition ratio of 1%.

In A2 using the active layer of the conventional structure, when thermal processing is performed at 950°C, the PL intensity sharply drops and the active layer deteriorates. This corresponds to the result shown in Fig. 10. Meanwhile, as to the active layer having the Al composition ratio of 0.25%, a good PL intensity is obtained at about 950°C and the PL intensity lowers by thermal processing at 1000°C. Therefore, A1 with added Al has improved heat resistance property as compared to A2 using the active layer of the conventional structure by T°C (50°C in this figure). In A3, Al is added to only the well layer by 1%. Here, the luminescence intensity lowers at 1000°C and the heat resistance property remains almost the same as that in A1, but the luminescence intensity lowers with an increase in the Al composition ratio. In A4 in which Al is added both to the well layer and the barrier layer by 1%, the heat resistance property is higher than that in A1 and A3 as apparent from Fig. 10, but the luminescence intensity is lower than that in A3.

As described above, the measurement results shown in Figs. 9 and 10 reveal that the active layer improves its heat resistance property as far as having even a little Al added thereto.

A method for manufacturing the nitride semiconductor element in Fig. 6 will be described. First, the sapphire substrate 11 is placed in the MOCVD (Metallic Organic Chemical Vapor Deposition) device and a hydrogen gas is caused to flow thereinto while the temperature is raised to about 1050°C to thermally clean the sapphire substrate 11. The temperature is kept as it is or lowered to an appropriate temperature of not less than 900°C to grow a high temperature AlN buffer layer 12. The growth temperature of the high temperature AlN buffer layer 12 needs to be 900°C or higher. For example, trimethyl aluminum (TMA) as a source gas for Al and ammonia (NH₃) as a source gas for N (nitrogen) are supplied to manufacture the high temperature AlN buffer layer.

Next, the growth temperature is raised to 1020°C to 1040°C, 20 µ moles of trimethylgallium (TMGa) per minute is supplied, for example, in addition to the supply of TMA, and silane (SiH₄) is supplied as an n-type dopant gas to grow the n-type AlGaN layer 13.

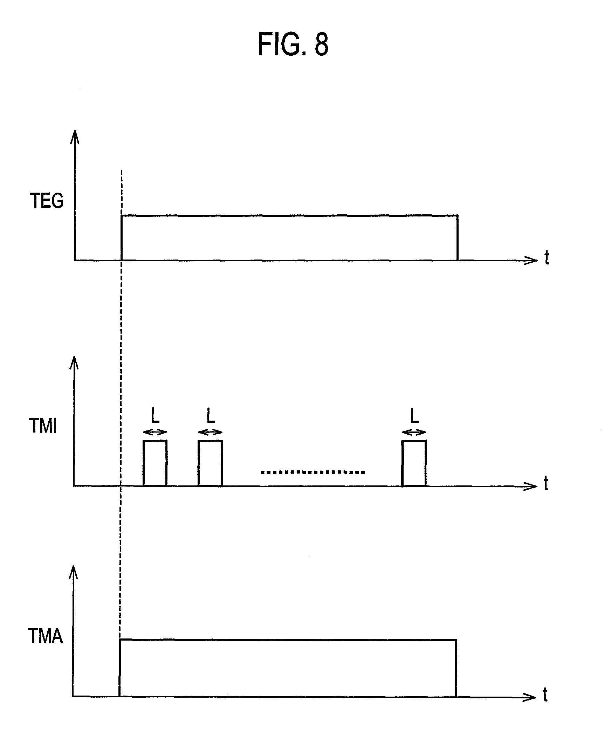

The description of the growth of the next active layer 14 is given with reference to Fig. 8. Nitrogen (N₂) as the carrier gas is caused to flow and triethylgallium (TEG) or trimethylgallium (TMG) as a source gas for Ga atoms, ammonia (NH₃) as a source gas for nitrogen atoms, and trimethyl aluminum (TMA) as a source gas for Al atoms are supplied. In the case of making the active layer 14 n-typed, silane (SiH₄) as a dopant gas is also supplied.

As well as NH₃ which is not not shown in the drawing, TEG, and TMA are continuously caused to flow, as apparent from Fig. 8, during manufacturing of the active layer 14. Trimethylindium (TMI) as a source gas for In atoms is caused to flow only when the well layer 14b is manufactured for time periods L, as shown in Fig. 8. A period when TMI is supplied and a period when supply of TMI is stopped are alternately set. In this manner, the well layer 14b is manufactured in the period corresponding to the period L and the barrier layer 14a is manufactured in a period other than the period L when supply of TMI is stopped. As a result, the barrier layer 14a and the well layer 14b are alternately formed.

As an example of the growth conditions, the growth temperature of the well layer 14b and that of the barrier layer 14a are both set to 730°C, the growth time (corresponding to the period L) of the well layer 14b is 0.86 minutes, the growth time of the barrier layer 4a is 7 minutes, TEG flow rate is 74 sccm, TMI flow rate is 115 sccm, and TMA flow rate is 10 to 200 sccm.

After the growth of the AlInGaN/AlGaN active layer 14, the supply of TMIn is stopped, the growth temperature is increased to 1020°C to 1040°C and trimethylgallium (TMGa) as a source gas for Ga atoms, ammonia (NH₃) as a source gas for nitrogen atoms and CP₂Mg (biscyclopentadiethyl magnesium) as a dopant material for the p-type impurity Mg are supplied to grow the p-type GaN layer 16.

Here, as an example of the growth film thickness, the high temperature AlN buffer layer 12 is set to 10 Å to 50 Å, the n-type AlGaN layer 13 is set to about 4µm, the AlInGaN/AlGaN active layer 14 is set to about 0.1µm, and the p-type GaN contact layer 16 is set to about 0.2 µm.

As described, after stacking up to the p-type GaN layer 16, a part of the n-type AlGaN layer 13 is exposed by mesa etching and the n electrode 18 is formed on the exposed surface. On the other hand, the p electrode 17 is formed on the p-type GaN layer 16.

As described above, if the AlN buffer layer 12 is the high temperature AlN buffer layer grown at the growth temperature of 900°C or higher, the growth temperature has only a small difference with the growth temperature of the n-type AlGaN layer 3. Thus, it is possible to prevent thermal distortion of the AlN buffer layer 12 which otherwise may occur due to difference in growth temperature..

Meanwhile, the AlN buffer layer 12 may be manufactured on the growing substrate as a low temperature AlN buffer layer having a film thickness of 100 to 500 Å (Angstrom) at the low growth temperature of 400 to 800°C. Here, the low temperature AlN buffer layer having smaller film thickness has the GaN film of better crystal quality because crystal axes of a GaN film crystal-grown on the buffer layer are more likely to be oriented uniformly.. However, the buffer layer having the smaller film thickness is more likely to cause the GaN film to have a hexagonal facet formed on the surface thereof, and thus the GaN film has poor surface morphology. Such a crystal involves a problem for the use of manufacturing a device.

To solve these problems, a method is proposed. In this method, a high temperature AlN buffer layer manufactured at a high temperature of 900°C or higher is grown on a growing substrate and then the nitride semiconductor crystal is layered thereon. However, growth conditions for the high temperature AlN buffer layer are strict, and the crystal quality and surface morphology of the nitride semiconductor crystal formed on the AlN buffer layer may deteriorate. Therefore, this method still has a difficulty in manufacturing a high-quality nitride semiconductor crystal.

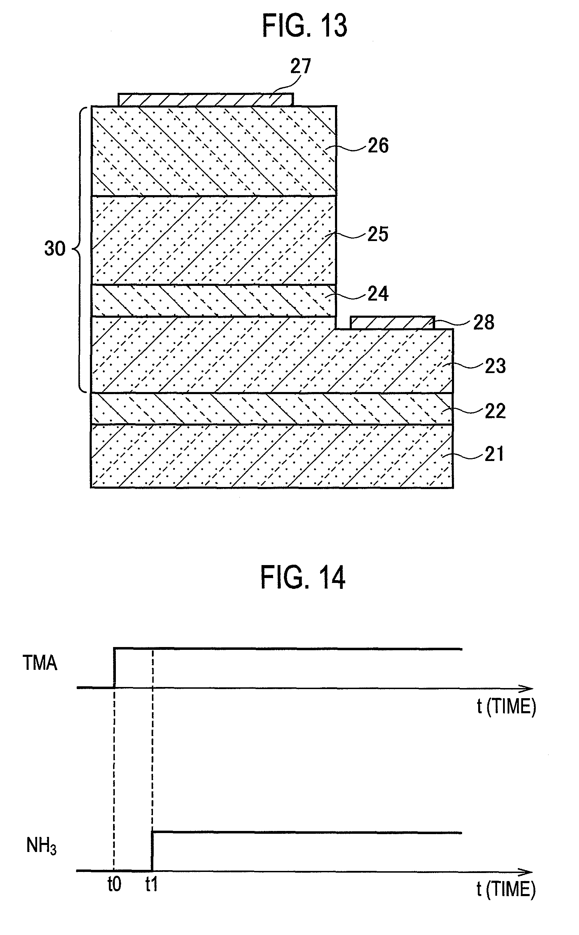

Conventionally, when the high temperature AlN buffer layer is manufactured,, trimethyl aluminum (TMA) as a group III gas and ammonia (NH₃) as a V group gas are used for example, and these source gases are supplied to the reaction chamber according to a time chart shown in Fig. 14. First, supply of TMA is started (ON) at a time point t0 and then supply of NH₃ is started (ON) at a time point t1. Once supply is put into the ON state, both the source gases TMA and NH₃ are caused to flow continuously until manufacturing of the high temperature AlN buffer layer is finished.

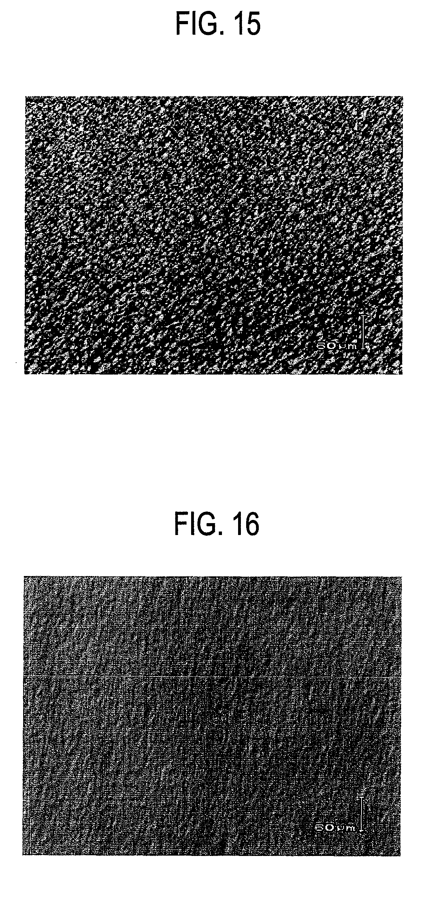

In the high temperature AlN buffer layer thus manufactured having the high molar ratio of NH₃/TMA, flatness of the surface of the nitride semiconductor crystal grown on the AlN buffer layer is deteriorated. Fig. 15 shows the surface of the GaN crystal grown on the AlN buffer layer manufactured to have the molar ratio of NH₃/TMA of 1800, which represents the rough surface.

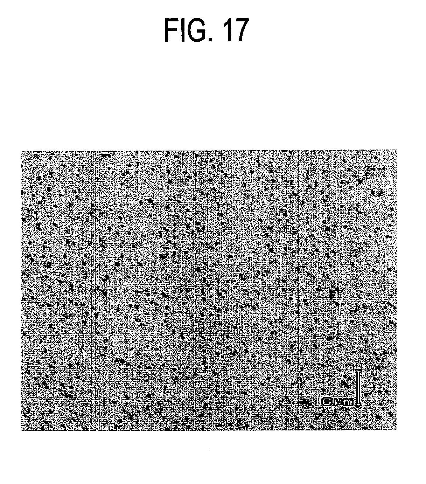

On the other hand, in the high temperature AlN buffer layer having the low molar ratio of NH₃/TMA, the crystal quality of the nitride semiconductor crystal grown on the high temperature AlN buffer layer is degraded. Each of Figs. 16, 17 shows this state. Fig. 16 shows the state of the surface of the GaN crystal grown on the AlN buffer layer and Fig. 17 shows the state of the inside of the GaN crystal. Here, the molar ratio of NH₃/TMA is set to 1200. Although flatness of the surface of the GaN crystal is greatly improved as shown in Fig. 16, Al is mixed in the GaN crystal as shown in Fig. 17, and thus degrades the crystal quality of the GaN crystal.

As described above, generally speaking, with the small molar ratio of N material/Al material of the supplied reactant gas, the crystal quality of the nitride semiconductor crystal on the high temperature AlN buffer layer is affected, while with the large molar ratio of N material/Al material, the surface morphology of the nitride semiconductor crystal is deteriorated.

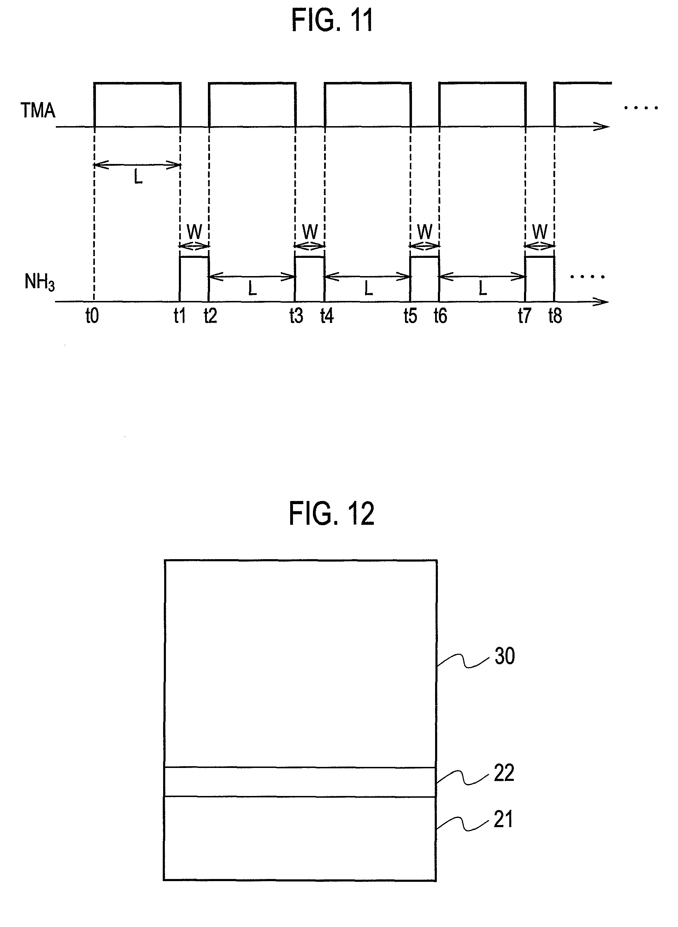

To address this situation, when the high temperature AlN buffer layers 1, 11 with the structure shown in Fig. 1 to Fig. 4, Fig. 6 according to the present invention are formed, the high temperature AlN buffer layer is manufactured in the following manner. Fig. 11 is a time chart showing a main process of the method for manufacturing the nitride semiconductor according to the present invention and Fig. 12 shows a basic structure of the nitride semiconductor manufactured by the method for manufacturing the nitride semiconductor according to the present invention.

An AlN buffer layer 22 is layered on a growing substrate 21 and a nitride semiconductor crystal 30 is crystal grown on the AlN buffer layer. This nitride semiconductor is formed by the known MOCVD method or the like. Here, the nitride semiconductor crystal 30 is an AlGaInN quaternary mixed crystal so called a III-V nitride semiconductor and can be expressed by AlxGayInzN (x + y + z = 1, 0 ≤ x ≤ 1, 0 ≤ y ≤ 1, 0 ≤ z ≤ 1).

Characteristic features of the present invention are that when crystal is grown on the AlN buffer layer 22, the crystal is grown at a high temperature of 900°C or higher and that trimethyl aluminum (TMA) used as Al material for the AlN buffer layer 22 and ammonia (NH₃) are alternately supplied. Here, trimethyl aluminum (TMA) may be supplied first to the reaction chamber or ammonia (NH₃) may be supplied first to the reaction chamber. However, it is desired that trimethyl aluminum (TMA) is supplied first to the reaction chamber.

In a time chart of Fig. 11, a horizontal axis represents time and a vertical axis represents an ON/OFF state of supply. Note that although not shown, the carrier gas such as hydrogen is caused to flow as a matter of course. According to the present invention, first, after supply of TMA is started (ON) at time point t0, TMA is intermittently supplied as shown in an upper part in Fig. 11 until the AlN buffer layer 22 having a predetermined film thickness is formed. Additionally, after supply of NH₃ is started (ON) at time point t1, NH₃ is also intermittently supplied as shown in a lower part in Fig. 11 until the AlN buffer layer 22 having the predetermined film thickness is formed. Furthermore, the supply of TMA and the supply of NH₃ are performed alternately, not concurrently.

First, the supply of TMA is started at time point t0. After TMA is continuously supplied for a period L, the supply of TMA is stopped (OFF) at time point t1 and at the same time, the supply of NH₃ is started.

Next, NH₃ is continuously supplied in a period W from time points t1 to t2. Then, the supply of NH₃ is stopped (OFF) at time point t2 and at the same time, the supply of TMA is started. In a period L from time points t2 to t3, TMA is continuously supplied in the period L from time points t2 to t3. Then, the supply of TMA is stopped (OFF) at time point t3 and at the same time, the supply of NH₃ is started. Next, in a period W from time points t3 to t4, NH₃ is supplied. Then, the supply of NH₃ is stopped at time point t4 and at the same time, the supply of TMA is started. After that, in a period L from time points t4 to t5, only TMA is supplied.

Similarly, in a period W from time points t5 to t6 and a period W from time points t7 to t8, the supply of TMA is stopped and only NH₃ is supplied, while in a period L from time points t6 to t7, the supply of NH₃ is stopped and only TMA is supplied. In this manner, only NH₃ is supplied in each period W and only TMA is supplied in each period L, so that NH₃ and TMA are alternately supplied in a repeated manner. The number of times to repeat W + L can be increased or decreased as necessary.

By alternately supplying the N (nitrogen) material and the Al (aluminum) material for AlN in a repeated manner as described above, the molar ratio of N material/Al material can be set to an appropriate value and Al can be prevented from being taken into the crystal quality of the nitride semiconductor crystal 30. Accordingly, it is possible to form the nitride semiconductor crystal 30 with good surface morphology.

Note that a growth pressure is set to 200 Torr, hydrogen is employed as the carrier gas, the flow rate of the carrier hydrogen (H₂) is set to 14 L/minute, the flow rate of TMA is set to 20 cc/minute, and the flow rate of NH₃ is set to 500 cc/minute. The molar ratio of NH₃/TMA at this time is calculated to be about 2600. It is possible to set W to be in the range of 4 to 30 seconds, L to be in the range of 3 to 18 seconds, and the number of times to repeat W + L to be in the range of 3 to 5. When W is set to 9 seconds, L is set to 6 seconds, and the number of times to repeat W + L is set to 5, for example, the AlN buffer layer having a film thickness of about 20 Å to 30 Å was formed. When the AlN buffer layer 22 is crystal grown in this manner, for example, the AlN buffer layer having a film thickness of 10 Å to 50 Å can be manufactured in about 75 seconds, while the conventional method shown in Fig. 14 requires the growth time of 10 to 15 minutes. Therefore, the use of the method of the present invention in Fig. 11 can greatly reduces the growth time for the AlN buffer layer.

While each of Fig. 1 to Fig. 4, and Fig. 6 shows a specific example of a structure of the nitride semiconductor crystal 30 layered on the AlN buffer layer 22 in Fig. 2, Fig. 13 shows another example. An n-type GaN contact layer 23 doped with Si at a concentration of 3 × 10¹⁸ cm⁻³, an n-type GaN layer 24 doped with Si at a concentration of 5 × 10¹⁶ cm⁻³, an MQW active layer 25, and a p-type GaN contact layer 26 doped with Mg are layered in this order on the AlN buffer layer 22 crystal grown on the sapphire substrate 21 as the growing substrate. The layers from the n-type GaN contact layer 23 to the p-type GaN contact layer 26 correspond to the nitride semiconductor crystal 30 in Fig. 12. These semiconductor layers are formed by the MOCVD method. The MQW active layer 25 has a multi quantum well structure formed of, for example, a barrier layer made of undoped GaN and a well layer made of undoped In_{X1}Ga_{1-X}1_{N} (0 < X1).

A method for manufacturing the nitride semiconductor in Fig. 13 will be described. First, the sapphire substrate 21 as the growing substrate is placed in the MOCVD (Metallic Organic Chemical Vapor Deposition) device and a hydrogen gas is caused to flow thereinto while the temperature is increased to about 1050°C to thermally clean the sapphire substrate 21. The temperature is kept as it is or lowered to an appropriate temperature of not less than 900°C to grow the high temperature AlN buffer layer 22. The growth temperature of the high temperature AlN buffer layer 22 needs to be 900°C or higher and is desirably set to be in the range of 900°C to 950°C.

As shown in Fig. 11, the reactant gas (for example, TMA) used as the Al material is first caused to continuously flow into the reaction chamber. Next, the reactant gas (for example, NH₃) used as the N material is supplied. This time the supply of the Al source gas is stopped. Thereafter, the Al source gas and the N source gas are alternately supplied to manufacture the high temperature AlN buffer layer 22.

Subsequently, the growth temperature is raised to 1020°C to 1040°C, and the supply of TMA is stopped. Then, 20 µ moles of trimethylgallium (TMGa) is supplied per minute for example, and silane (SiH₄) as the n-type dopant gas is supplied to grow the n-type GaN contact layer 23. After that, the amount of silane (SiH₄ supply is decreased to form the n-type GaN layer 24 which is a low-doped layer and which serves as the cladding layer.

Next, the supply of TMGa and silane is stopped, and a substrate temperature is decreased to fall within the range of 700°C to 800°C in a mixed atmosphere of ammonia and hydrogen. Then, 200 µ moles of trimethylindium (TMIn) per minute and 20 µ moles of triethylgallium (TEGa) per minute are supplied to stack the undoped InGaN well layer of the MQW active layer 25, and thereafter the supply of only TMIn is stopped to stack the barrier layer made of undoped GaN. Then, the GaN barrier layer and the InGaN well layer are repeatedly layered to form a multi quantum well structure.

After the growth of the MQW active layer 25, the growth temperature is increased to 1020°C to 1040°C. Then, trimethylgallium (TMGa) as a source gas for Ga atoms, ammonia (NH₃) as a source gas for nitrogen atoms, and CP₂Mg (biscyclopentadiethyl magnesium) as a dopant material for the p-type impurity Mg are supplied to grow the p-type GaN contact layer 26.

When the growth temperature of the AlN buffer layer 22 is set to be in the range of 900°C to 950°C as described above, the growth temperature only has a small difference with the growth temperature of the n-type GaN contact layer 23. Thus, it is possible to prevent thermal distortion of the AlN buffer layer 22 which otherwise may occur due to difference in growth temperature. As to an example of the structure such as the growth film thickness, the high temperature AlN buffer layer 22 is set to 10 Å to 50 Å, the n-type GaN contact layer 23 is set to 4 to 6 µm, the n-type GaN cladding layer 24 is set to about 200 nm, and the MQW active layer 25 has a multi quantum well structure obtained by alternately stacking the InGaN well layer having a film thickness of 20 Å to 30 Å and the GaN barrier layer having a film thickness of 120 Å to 180 Å in eight cycles. In addition, the p-type GaN contact layer 26 is formed so as to have a film thickness of about 0.2 µm, is grown at a low temperature unlike the above-mentioned growth temperature, and is modulation-doped with the p-type impurity Mg to form a p-type GaN layer. Also note that, although not shown, a ZnO electrode (transparent electrode) may be formed on the p-type GaN contact layer 26 and a DBR layer (light reflection layer) made of an oxide film or the like may be formed on the ZnO electrode.

After the nitride semiconductor crystal is formed in this manner, a part of the n-type GaN contact layer 23 is exposed by mesa etching and an n electrode 28 is formed on the exposed surface. Meanwhile, a p electrode 27 is formed on the p-type GaN contact layer 26.

Each of the p electrode 27 and the n electrode 28 has an Al or Al/Ni metallic multi-layered film structure. When the Al/Ni structure is employed, each film is formed to have the thickness of, for example, 3000 Å/500 Å.

Incidentally, as described above, the p-type GaN contact layer 26 can be grown at a low temperature of 900°C or lower to form the p-type GaN layer modulation-doped with the p-type impurity. This method will be described below in detail.

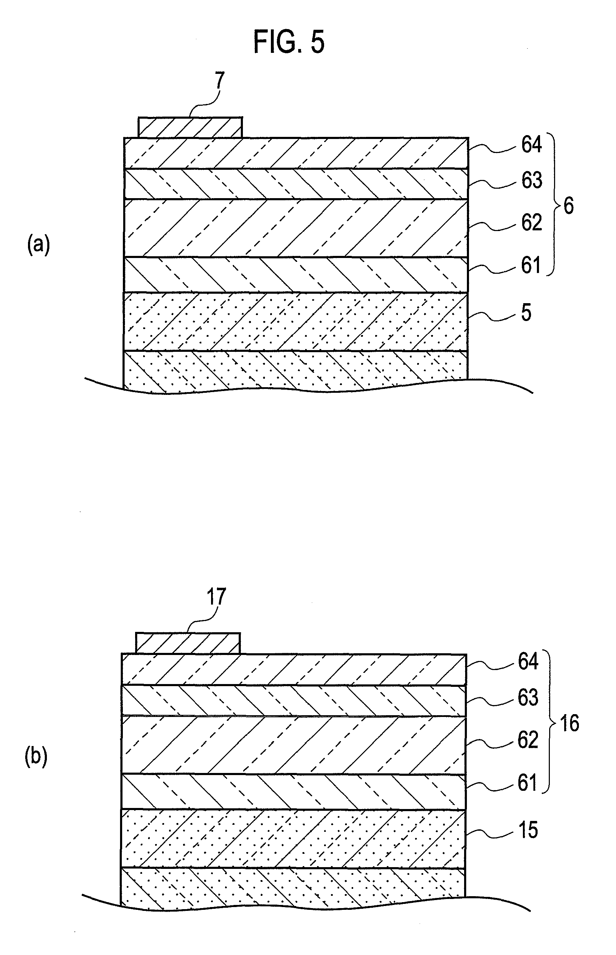

Fig. 5 shows an example in which each of the p-type GaN layers 6, 16 shown in Fig. 1 to Fig. 4 is formed to have a four-layered structure. Fig. 5(a) shows the case where the p-type GaN layer 6 in each of Figs. 1, 3 has a four-layered structure and Fig. 5(b) shows the case where the p-type GaN layer 16 in each of Figs. 2, 4 has a four-layered structure. For example, each of the p-type GaN layers 6, 16 is doped with the p-type impurity so as to have a film thickness of about 0.05 to 1 µm. As the p-type impurity, magnesium (Mg), zinc (Zn), cadmium (Cd), calcium (Ca), beryllium (Be), carbon (C), and the like can be used.

An example of the structure of the p-type GaN layers 6, 16 will be described below in detail. Specifically, as shown in Figs. 5(a) and (b), the p-type GaN layers 6, 16 each include: a first p-type GaN layer 61 formed on the p-type cladding layers 5, 15; a second p-type GaN layer 62 which is formed on the first p-type GaN layer 61 and contains a p-type impurity at a lower concentration than the p-type impurity in the first p-type GaN layer 61; a third p-type GaN layer 63 which is formed on the second p-type GaN layer 62 and contains a p-type impurity at a higher concentration than the p-type impurity in the second p-type GaN layer 62; and a fourth p-type GaN layer 64 which is formed on the third p-type GaN layer 63 and contains a p-type impurity at a lower concentration than the p-type impurity in the third p-type GaN layer 63. In this manner, the concentration of the p-type impurity is modulated in a way that the p-type GaN layers at concentrations of high, low, high, and low, alternately are stacked starting from the p-type GaN layer which is disposed close to any of the active layers 4, 14.

The thickness of the second p-type GaN layer 62 is formed to be larger than the thickness of any of the first p-type GaN layer 61, the third p-type GaN layer 63, and the fourth p-type GaN layer 64.

Here, material and thickness of each layer will be specifically described. The first p-type GaN layer 61 is formed so as to have a p-type impurity Mg at a concentration of about 2 × 10²⁰ cm⁻³ and a film thickness of about 50 nm. The second p-type GaN layer 62 placed on the first p-type GaN layer 61 is doped with the p-type impurity at a concentration lower than the first p-type GaN layer 61 and, for example, is formed so as to have a p-type impurity Mg at a concentration of about 4 × 10¹⁹ cm⁻³ and a film thickness of about 100 nm. The third p-type GaN layer 63 disposed on the second p-type GaN layer 62 is doped with the p-type impurity of at a concentration higher than the second p-type GaN layer 62 and, for example, is formed so as to have a p-type impurity Mg at a concentration of about 1 × 10²⁰ cm⁻³ and a film thickness of about 40 nm. The fourth p-type GaN layer 64 disposed on the third p-type GaN layer 63 is doped with the p-type impurity of at a concentration lower than the third p-type GaN layer 63 and, for example, is formed so as to have a p-type impurity Mg at a concentration of about 8 × 10¹⁹ cm⁻³ and has a film thickness of about 10 nm.

As described above, each of the p-type GaN layers 6, 16 has a layered structure which is obtained by stacking four layers at different Mg concentrations of the first p-type GaN layer 61 to fourth p-type GaN layer 64. The first p-type GaN layer 61 to fourth p-type GaN layer 64 are grown at a low temperature of about 800°C to 900°C to reduce thermal damage exerted on the active layers 4, 14.

It is preferable that the Mg concentration of the first p-type GaN layer 61 which is the closest to the active layer is as high as possible, because the luminescence intensity becomes higher as the Mg concentration is higher. It is desired that the Mg concentration of the second p-type GaN layer 62 is in the middle of the 10¹⁹ cm⁻³ digits because excessive addition of impurity Mg increases crystal failure attributable to Mg and increases film resistance as well. Since the third p-type GaN layer 63 is a layer which is used to determine the amount of hole injection to the active layer, it is desired that the Mg concentration of the third p-type GaN layer 63 is slightly higher than the Mg concentration of the second p-type GaN layer 62. The fourth p-type GaN layer 64 is a layer for ohmic contact with the p electrodes 7, 17 and is substantially depleted. The fourth p-type GaN layer 64 is doped with the impurity Mg at the Mg concentration, which is equivalent to that at the time when the forward voltage V_{f} of the semiconductor light emitting element is the lowest.

When four layers from the first p-type GaN layer 61 to fourth p-type GaN layer 64 are to be crystal grown, the amount of a H₂ gas in the carrier gas is increased since the third p-type GaN layer 63 and the fourth p-type GaN layer 64 which are close to the p electrode need to have the hole concentration thereof increased. On the other hand, the amount of H₂ gas in the carrier gas do not need to be increased for the first p-type GaN layer 61 and the second p-type GaN layer 62 which are close to the active layer, and these layers are crystal grown with the N₂ carrier gas having the same conditions for the growth of the active layer. When these p-type GaN layers are grown, the higher possible molar ratio of a V group gas and a III group gas (V/III) can grow a lower resistance film, thereby lowering the forward voltage (V_{f}) of the light emitting element.

As described above, by forming the first p-type GaN layer 61 to fourth p-type GaN layer 64 at a low temperature, it is possible to reduce thermal damage exerted on the active layer, to lower the forward voltage (V_{f}), and to improve the light emitting efficiency.

Next, a method for manufacturing the first p-type GaN layer 61 to fourth p-type GaN layer 64 which constitute the p-type GaN layers 6, 16 will be described below. As described above, the first p-type GaN layer 61 to fourth p-type GaN layer 64 are formed at the substrate temperature of about 800°C to 900°C so as to have a total film thickness of about 0.05 to 1 µm.

When Mg is doped as the p-type impurity, a biscyclopentadienyl magnesium (Cp₂Mg) gas is used as a source gas. Biscyclopentadienyl magnesium gas is supplied along with a TMG gas as a source gas for Ga and an NH₃ gas as a source gas for N for the p-type GaN layer to form the first p-type GaN layer 61 to fourth p-type GaN layer 64.

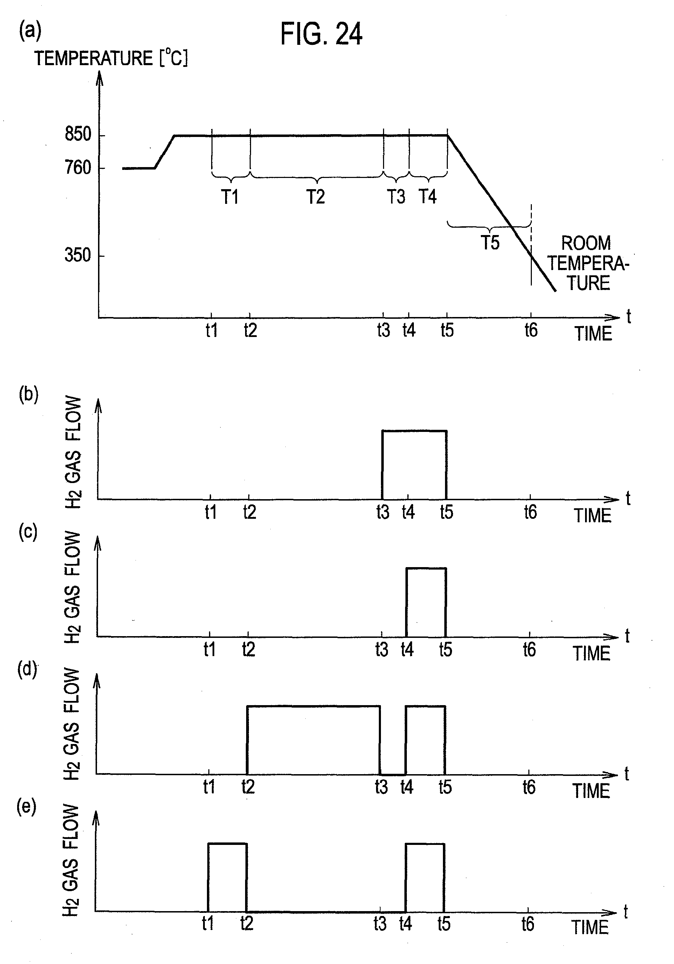

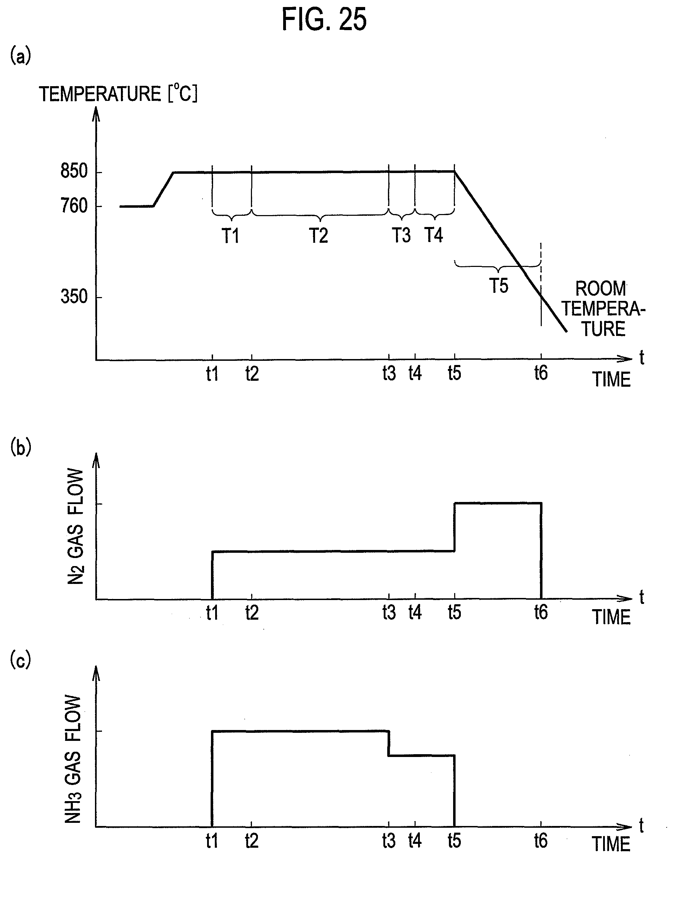

Fig. 24 is a chart for illustrating a growth temperature distribution (a) and flow conditions of a hydrogen gas as the carrier gas (b) to (e) at manufacturing of the first p-type GaN layer 61 to fourth p-type GaN layer 64. Meanwhile, Fig. 25 is a chart for illustrating a growth temperature distribution (a) and conditions of nitrogen gas flow (b) and ammonia gas flow (c) at formation of the first p-type GaN layer 61 to fourth p-type GaN layer 64.

In the growth temperature distribution shown in Fig. 24(a) and Fig. 25(a), a period T1 from time points t1 to t2 is a period for forming the first p-type GaN layer 61, a period T2 from time points t2 to t3 is a period for forming the second p-type GaN layer 62, a period T3 from time points t3 to t4 is a period for forming the third p-type GaN layer 63, and a period T4 from time points t4 to t5 is a period for forming the fourth p-type GaN layer 64. A period T5 from time points t5 to t6 is a period for cooling the substrate temperature from 850°C down to 350°C.

As shown in Fig. 24, the first p-type GaN layer 61 to fourth p-type GaN layer 64 are formed at a low temperature of about 800°C to 900°C and the carrier gas containing no hydrogen is supplied as the source gas to form at least one of the plurality of p-type GaN layers 61 to 64. Here, in a case where the nitride is grown by the CVD method, hydrogen (H₂), nitrogen (N₂) or a mixed gas of hydrogen and nitrogen is generally and frequently used as the carrier gas. An example of the carrier gas containing no hydrogen is a gas formed of only nitrogen gas, and examples of the carrier gas containing hydrogen include a gas formed of only hydrogen, a mixed gas of hydrogen and nitrogen, and other gases.

If the p-type GaN layer is formed by using the carrier gas containing hydrogen, hydrogen atoms taken along with Mg makes Mg inactive and inhibits the p-type GaN layer to be p-typed. To avoid this happening, after the formation of the p-type GaN layer, annealing for removing the hydrogen atoms to make the p-type GaN layer p-typed (hereinafter referred to as "p-type annealing") needs to be performed.

In this embodiment, however, the process of p-type annealing can be omitted for at least one of the first p-type GaN layer 61 to fourth p-type GaN layer 64, which is formed by supplying the carrier gas containing no hydrogen as the source gas for Mg. It can be set as appropriate as to which part of the first p-type GaN layer 61 to fourth p-type GaN layer 64 is formed by supplying the carrier gas containing no hydrogen.

In light of the omission of the p-type annealing process, it is preferred that the second p-type GaN layer 62 having a large film thickness or the first p-type GaN layer 61 at a high Mg concentration, for example, among the first p-type GaN layer 61 to fourth p-type GaN layer 64 is formed by supplying the carrier gas containing no hydrogen as shown in Fig. 24(b). For example, Fig. 24(c) shows an example in which the first p-type GaN layer 61 to third p-type GaN layer 63 are formed by supplying the carrier gas containing no hydrogen. Fig. 24(d) shows an example in which the first p-type GaN layer 61 and the third p-type GaN layer 63 are formed by supplying the carrier gas containing no hydrogen. Fig. 24(e) shows an example in which the second p-type GaN layer 62 and the third p-type GaN layer 63 are formed by supplying the carrier gas containing no hydrogen.

On the other hand, as shown in Fig. 24(b) to Fig. 24(e), it is preferred that the fourth p-type GaN layer 64 which is in contact with any of the p electrodes 7, 17 is formed by supplying the carrier gas containing hydrogen as the source gas for Mg in order to achieve the better crystal state as much as possible. This is because the p-type semiconductor layer doped with Mg generally has the better crystal state in the case where the layer is formed by supplying the carrier gas containing hydrogen as the source gas for Mg, than that obtained in the case of forming the layer by supplying the carrier gas containing no hydrogen.

With reference to Fig. 24 and Fig. 25, an example of the method for manufacturing the first p-type GaN layer 61 to fourth p-type GaN layer 64 will be described in detail. Although Mg is used as the p-type impurity here, the above-mentioned other p-type impurities may be used instead. As shown in Fig. 24(b), the description is given of the case, as a typical example, where the first p-type GaN layer 61 and the second p-type GaN layer 62 are formed by supplying the carrier gas containing no hydrogen and the third p-type GaN layer 63 and the fourth p-type GaN layer 64 are formed by supplying the carrier gas containing hydrogen.

As shown in Fig. 24 and Fig. 25, each of the first p-type GaN layer 61 to fourth p-type GaN layer 64 is formed at a commonly set substrate temperature Tp of 850°C and pressure of 200 Torr.

First, in a first step, from time point t1 to time point t2, a N₂ gas as the carrier gas is supplied, and a NH₃ gas, a TMG gas, and biscyclopentadienyl magnesium (Cp₂Mg) gas as source gases are supplied to a growth chamber of the MOCVD device to form the first p-type GaN layer 61. The period between time point t1 to time point t2 lasts for five minutes. The first p-type GaN layer 41 having a film thickness of 50 nm and at an Mg concentration of 2 × 10²⁰ cm⁻³ is formed.

In a second step, that is, from time point t2 to time point t3, the N₂ gas as the carrier gas is supplied, and the NH₃ gas, the TMG gas, and the Cp₂Mg gas as source gases are supplied to the growth chamber to form the second p-type GaN layer 62. The period between time point t2 to time point t3 lasts for 21 minutes. The second p-type GaN layer 62 having the film thickness of 100 nm and at an Mg concentration of 4 × 10¹⁹ cm⁻³ is formed.

In a third step, that is, from time point t3 to time point t4, a mixed gas of the H₂ gas and the N₂ gas as the carrier gas is supplied, and the NH₃ gas, the TMG gas and the Cp₂Mg gas as source gases are supplied to the growth chamber to form the third p-type GaN layer 63. The period between time point t3 to time point t4 lasts for 1 minute. The third p-type GaN layer 63 having a film thickness of 40 nm and at an Mg concentration of 1 × 10²⁰ cm⁻³ is formed.

In a fourth step, that is, from time point t4 to time point t5, the mixed gas of the H₂ gas and the N₂ gas as the carrier gas is supplied, and the NH₃ gas, the TMG gas and the Cp₂Mg gas as source gases are supplied to the growth chamber to form the fourth p-type GaN layer 64. The period between time point t4 to time point t5 lasts for 3 minutes. The fourth p-type GaN layer 64 having a film thickness 10 nm and at an Mg concentration of 8 × 10¹⁹ cm⁻³ is formed.

In a fifth step, that is, from time point t5 to time point t6, the substrate temperature is decreased from the temperature Tp (850°C) down to the temperature Td (350°C) or less while the N₂ gas is supplied as the carrier gas. In other words, the p-type annealing to be performed at 400°C or higher is not carried out here.

By the above-mentioned first to fifth steps, the first p-type GaN layer 61 to fourth p-type GaN layer 64 are formed. Since the first p-type GaN layer 61 at a high Mg concentration and the second p-type GaN layer 62 having a large film thickness are formed by supplying the carrier gas containing no H₂ gas, the p-type GaN layers 6, 16 can be made p-typed even without the performance of the p-type annealing. Furthermore, being formed by supplying the carrier gas containing the H₂ gas, the fourth p-type GaN layer 64 has the better crystal state. As the fourth p-type GaN layer 64 has the surface of the better crystal state which is in contact with the p electrodes 7, 17, ohmic contact with the p electrodes 7, 17 can be achieved.

In the above-mentioned manufacturing process of the p-type GaN layers 6, 16, the p-type GaN layers 6, 16 each have a multi-layered structure, the GaN layer which focuses on activation of the p-type impurity is selected, and the selected GaN layer is formed by supplying the carrier gas containing no H₂ gas. Since H₂ is not taken in along with the p-type impurity, the p-type annealing is not required for the selected GaN layer. This makes the manufacturing process shortened.

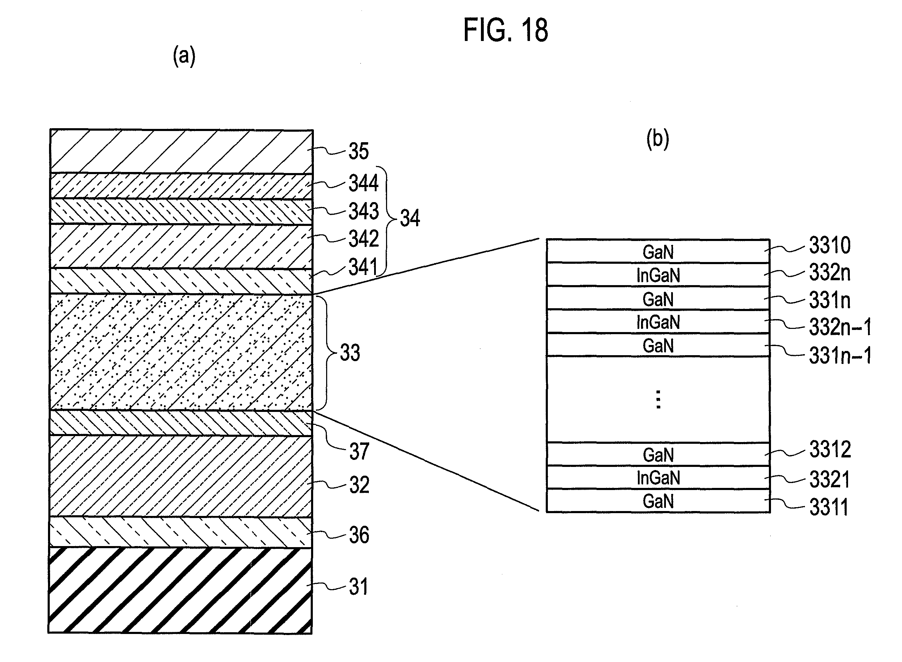

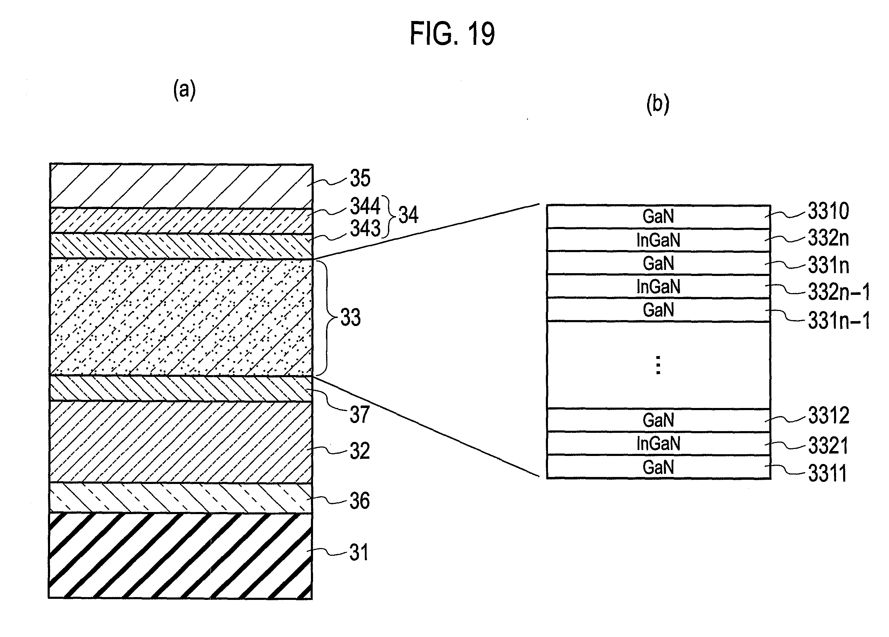

Next, the description is given below of the basic structure of the nitride semiconductor light emitting element formed with a view to crystal growing the above-mentioned p-type contact layer at the substrate temperature of 900°C or lower, and then modulation doping the p-type impurity, and to defining the appropriate number of pairs or the like of the well layer and the barrier layer in the MQW active layer. Figs. 18, 19 show a structure of the nitride semiconductor light emitting element generalized by the nitride semiconductor.

Fig. 18(a) shows an example of a schematic sectional structure of the nitride semiconductor light emitting element according to the present invention and Fig. 18(b) shows a schematic enlarged sectional structure of the active layer part.

As shown in Fig. 18, a first nitride semiconductor light emitting element in this embodiment includes: a substrate 31; a buffer layer 36 disposed on the substrate 31; an n-type semiconductor layer 32 which is disposed on the buffer layer 36 and is doped with the n-type impurity; a block layer 37 which is disposed on the n-type semiconductor layer 32 and is doped with the n-type impurity at a lower concentration than the n-type impurity doped to n-type semiconductor layer 32; an active layer 33 disposed on the block layer 37; a p-type semiconductor layer 34 disposed on the active layer 33; and an oxide electrode 35 disposed on the p-type semiconductor layer 34.

As shown in Fig. 18(b), the active layer 33 has a layered structure in which barrier layers 3311 to 331n, 3310 and well layers 3321 to 332n having a smaller band gap than the barrier layers 3311 to 331n, 3310 are alternately stacked. Hereinafter, the first barrier layer 3311 to the n^{th} barrier layer 331n which are included in the active layer 33 are collectively referred to as "a barrier layer 331". Further, all the well layers included in the active layer 33 are collectively referred to as "a well layer 332".

The film thickness of the topmost last barrier layer 3310 in the above-mentioned layered structure may be formed to be larger than any other barrier layers (first barrier layer 3311 to the n^{th} barrier layer 331n) in the layered structure except the last barrier layer 3310.

In the nitride semiconductor light emitting element shown in Fig. 18, the concentration of the p-type dopant of the last barrier layer 3310 gradually decreases from a first main surface of the last barrier layer 3310 which is in contact with the p-type semiconductor layer 34 in the direction of the film thickness of the last barrier layer 3310, and the p-type dopant does not exist in a second main surface opposed to the first main surface.

For example, a sapphire substrate having a 0.25° off-angle main surface slanted from a c face (0001) can be employed as the substrate 31. The n-type semiconductor layer 32, the active layer 33 and the p-type semiconductor layer 34 each are formed of the III group nitride semiconductor, and the buffer layer 36, the n-type semiconductor layer 32, the block layer 37, active layer 33 and the p-type semiconductor layer 34 are layered sequentially on the substrate 31.

### (AIN Buffer Layer)

The buffer layer 36 is formed of an AIN layer having a thickness of, for example, about 10 to 50 Angstrom. As described above, the AlN buffer layer 36 is crystal grown at a high temperature in the range of about 900°C to 950°C. The AIN buffer layer 36 is crystal grown by supplying, to the reaction chamber, trimethyl aluminum (TMA) used as the Al material for the AIN buffer layer 36, ammonia (NH₃) used as the N material therefor, and the H₂ gas as the carrier gas, alternately in a pulsed manner as shown in Fig. 11. When being grown in the manner as shown in Fig. 11, the thin AIN buffer layer 36 having a thickness of about 10 to 50 Angstrom can be grown at high speed and formed with good crystal quality.

### (Block Layer)

The block layer 37 disposed between the n-type semiconductor layer 32 and the active layer 33 can employ the III group nitride semiconductor such as a GaN layer, for example, having a film thickness of about 200 nm which is doped with, for example, Si as the n-type impurity at a concentration of 1 × 10¹⁷ cm⁻³.

In the nitride semiconductor light emitting element shown in Fig. 18, diffusion of Si from the n-type semiconductor layer 2 to the active layer 3 can be prevented in the forming process of the active layer 33 and the manufacturing process following the forming process of the active layer 33 in the following case. Specifically, such a case is where the block layer 37 doped with the Si at a concentration of about 8 × 10¹⁶ cm⁻³ as impurity is disposed between the n-type semiconductor layer 32 and the active layer 33, on the condition, for example, that the n-type semiconductor layer 32 is doped with Si at a concentration of about 3 × 10¹⁸ cm⁻³ as impurity.

In other words, Si does not diffuse in the active layer 33 and the luminance of light occurring at the active layer 33 is prevented from lowering. Furthermore, when bias is applied between the n-type semiconductor layer 32 and the p-type semiconductor layer 34 to cause light emission at the active layer 33, electrons supplied from the n-type semiconductor layer 32 to the active layer 33 can be prevented from passing through the active layer 33 and reaching the p-type semiconductor layer 34, that is, overflow of electrons can be prevented. Therefore, the luminance of light outputted from the nitride semiconductor light emitting element can be prevented from lowering.

The Si concentration of the block layer 37 is set to be less than 1 × 10¹⁷ cm⁻³. This is because, Si at the excessively high concentration of the block layer 37 will cause electrons supplied from the n-type semiconductor layer 32 to pass through the active layer 33, thus to overflow to the p-type semiconductor layer 34, and finally to recombine with holes in the p-type semiconductor layer 34. This results in decrease in proportion of recombination in the active layer 33, and decrease in luminance of light occurring at the active layer 33. On the other hand, Si at the excessively low concentration the block layer 37 prevents the carrier density of electrons from increasing, the electrons injected from the n-type semiconductor layer 32 to the active layer 33. For this reason, it is preferred that the Si concentration of the block layer 37 is about 5 × 10¹⁶ to 1 × 10¹⁷ cm⁻³_{.}

As described above, in the first nitride semiconductor light emitting element, the block layer 37 is disposed between the n-type semiconductor layer 32 and the active layer 33. This prevents diffusion of Si from the n-type semiconductor layer 32 to the active layer 33 in the manufacturing process as well as the electron overflow from the n-type semiconductor layer 32 to the p-type semiconductor layer 34 at light emission so that the luminance of light outputted from the nitride semiconductor light emitting element can be prevented from lowering. As a result, deterioration of the quality of the nitride semiconductor light emitting element shown in Fig. 1 can be prevented.

### (n-type Semiconductor Layer)

The n-type semiconductor layer 32 supplies electrons to the active layer 33 and the p-type semiconductor layer 34 supplies holes to the active layer 33. The supplied electrons and holes are recombined with each other in the active layer 33, thereby light emission occurs.

The III group nitride semiconductor such as a GaN layer which is doped with the n-type impurity such as silicon (Si) and has a film thickness of about 1 to 6 µm can be employed as the n-type semiconductor layer 32.

### (p-type Semiconductor Layer)

The III group nitride semiconductor such as a GaN layer which is doped with the p-type impurity and has a film thickness of about 0.05 to 1 µm can be employed as the p-type semiconductor layer 34. Magnesium (Mg), zinc (Zn), cadmium (Cd), calcium (Ca), beryllium (Be), and carbon (C) can be used as the p-type impurity.

An example of a structure of the p-type semiconductor layer 34 will be described hereinbelow in more detail. Specifically, as shown in Fig. 18(a), the p-type semiconductor layer 34 includes: a first nitride semiconductor layer 341 which is disposed on top of the active layer 33 and contains the p-type impurity; a second nitride semiconductor layer 342 which is disposed on the first nitride semiconductor layer 341 and contains the p-type impurity at a lower concentration than the p-type impurity of the first nitride semiconductor layer 341; a third nitride semiconductor layer 343 which is disposed on the second nitride semiconductor layer 342 and contains the p-type impurity at a higher concentration than the p-type impurity of the second nitride semiconductor layer 342; and a fourth nitride semiconductor layer 344 which is disposed on the third nitride semiconductor layer 343 and contains the p-type impurity at a lower concentration than the p-type impurity of the third nitride semiconductor layer 343.

The thickness of the second nitride semiconductor layer 342 is formed to be larger than the thickness of each of the first nitride semiconductor layer 341, the third nitride semiconductor layer 343, and the fourth nitride semiconductor layer 344.

Here, material and thickness of each layer are specifically described. The first nitride semiconductor layer 341 which is disposed on top of the active layer 3 and contains the p-type impurity is formed of, for example, a p-type GaN layer which is doped with Mg as the impurity at a concentration of about 2 × 10²⁰ cm⁻³ and has a thickness of about 50 nm.

The second nitride semiconductor layer 342 which is disposed on the first nitride semiconductor layer 341 and contains the p-type impurity at a lower concentration than the p-type impurity of the first nitride semiconductor layer 341 is formed of, for example, a p-type GaN layer which is doped with Mg as the impurity at a concentration of about 4 × 10¹⁹ cm⁻³ and has a thickness of about 100 nm.

The third nitride semiconductor layer 343 which is disposed on the second nitride semiconductor layer 342 and contains the p-type impurity at a higher concentration than the p-type impurity of the second nitride semiconductor layer 342 is formed of, for example, a p-type GaN layer which is doped with Mg as the impurity at a concentration of about 1 × 10²⁰ cm⁻³ and has a thickness of about 40 nm.

The fourth nitride semiconductor layer 344 which is disposed on the third nitride semiconductor layer 343 and contains the p-type impurity at a lower concentration than the p-type impurity of the third nitride semiconductor layer 343 is formed of, for example, a p-type GaN layer which is doped with Mg as the impurity at a concentration of about 8 × 10¹⁹ cm⁻³ and has a thickness of about 10 nm.

In the nitride semiconductor light emitting element according to first embodiment of the present invention, as described above, the p-type semiconductor layer 34 formed on the active layer 33 formed of the multi quantum well containing indium is the p-type GaN layer having the structure of four layers at different Mg concentrations and is doped with Mg at the above-mentioned concentrations. The p-type GaN layer is grown at a low temperature of about 800°C to 900°C to reduce thermal damage exerted on the active layer 33.

It is preferable that the Mg concentration of the first nitride semiconductor layer 341 which is the closest to the active layer is as high as possible, because the luminescence intensity becomes higher as the Mg concentration is higher.

It is desired that the Mg concentration of the second nitride semiconductor layer 342 is in the middle of the 10¹⁹ cm⁻³ digits because excessive addition of impurity Mg increases crystal failure attributable to Mg and increases film resistance as well.

Since the third nitride semiconductor layer 343 is a layer which is used to determine the amount of hole injection to the active layer 33, it is desired that the Mg concentration of the third nitride semiconductor layer 343 is slightly higher than the Mg concentration of the second nitride semiconductor layer 342.

The fourth nitride semiconductor layer 344 is a p-type GaN layer layer for ohmic contact with the oxide electrode 35 and is substantially depleted. When the ZnO electrode doped with impurity Ga or Al at a concentration of about 1 × 10¹⁹ to 5 × 10²¹ cm⁻³ is used, for example, as the oxide electrode 35, the fourth nitride semiconductor layer 344 is doped with the impurity Mg at the Mg concentration, which is equivalent to that at the time when the forward voltage V_{f} of the nitride semiconductor light emitting element is the lowest.

When 34 p-type GaN layers are to be grown, the amount of a H₂ gas in the carrier gas is increased since the third nitride semiconductor layer 343 and the fourth nitride semiconductor layer 344 which are close to the p electrode 40 need to have the hole concentration thereof increased. On the other hand, the amount of H₂ gas in the carrier gas do not need to be increased for the first nitride semiconductor layer 341 and the second nitride semiconductor layer 342 which are close to the active layer 33, and these layers are crystal grown with the N₂ carrier gas having the same conditions for the growth of the active layer 3. When these p-type GaN layers are grown, the higher possible V/III ratio can grow a lower resistance film, thereby lowering the forward voltage (V_{f}) of the light emitting element.

In the first nitride semiconductor light emitting element according to the present invention, by forming the p-type semiconductor layer at a low temperature, it is possible to reduce thermal damage exerted on the active layer, to lower the forward voltage (V_{f}), and to improve the light emitting efficiency.

### (Active Layer)

As shown in Fig. 18(b), the active layer 33 has a multi quantum well (MQW) structure in which each of a first well layer 3321 to an n^{th} well layer 332n is sandwiched between any adjacent two of the first barrier layer 3311 to the n^{th} barrier layer 331n and a last barrier layer 3310 (n is a natural number). In other words, the active layer 33 has an n pair structure obtained by stacking a unit pair structure n times, the unit pair structure defined as a quantum well structure having the well layer 332 sandwiched between barrier layers 331 each having a larger band gap than the band gap of the well layer 332.

Specifically, the first well layer 3321 is disposed between the first barrier layer 3311 and the second barrier layer 3312, and the second well layer 3322 is disposed between the second barrier layer 3312 and the third barrier layer 3313. Then, the n^{th} well layer 332n is disposed between the n^{th} barrier layer 331n and the last barrier layer 3310. The first barrier layer 3311 of the active layer 33 is disposed on the n-type semiconductor layer 32 with the buffer layer 36 interposed in between and the p-type semiconductor layer 34 (341 to 344) is disposed on top of the last barrier layer 3310 of the active layer 33.

The well layers 3321 to 332n each are formed of, for example, an InₓGa₁₋ₓN (0 < x < 1) layer and the barrier layers 3311 to 331n, 3310 each are formed of, for example, a GaN layer. The number of pairs of the multi quantum well layers is characteristically 6 to 11, for example. The ratio of gallium (Ga) to indium (In) {x/(1-x)} in the well layers 3321 to 332n is appropriately set according to the desired wavelength of light to be emitted.

Characteristically, the thickness of each of the well layers 3321 to 332n is, for example, about 2 to 3 nm, desirably about 2.8 nm and the thickness of each of the barrier layers 3311 to 331n is about 7 to 18 nm, desirably, about 16.5 nm.

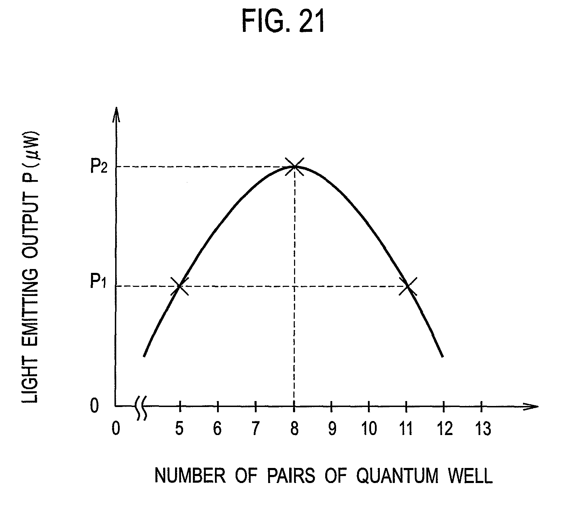

Fig. 21 shows relationship between the light emission output and the number of quantum well pairs in the first nitride semiconductor light emitting element according to the present invention.

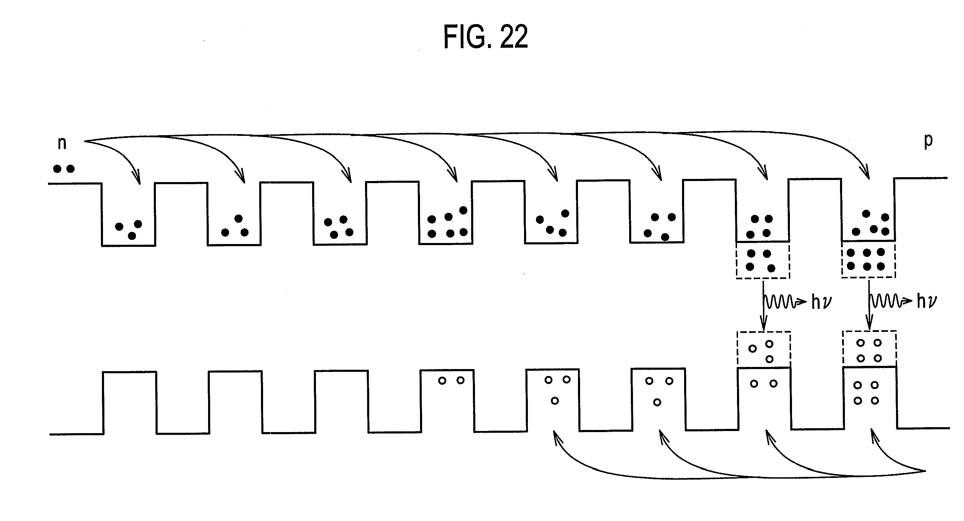

Fig. 22 is a schematic diagram of a band structure for illustrating a luminous phenomenon in the active layer 33 in the first nitride semiconductor light emitting element according to the present invention.

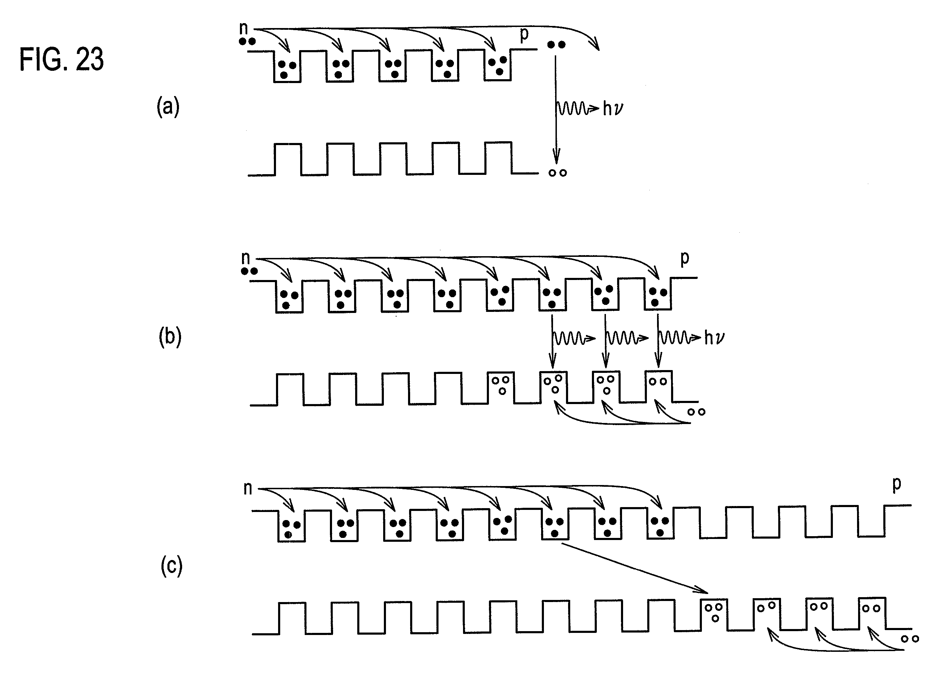

Fig. 23 shows a band structure for illustrating a luminous phenomenon in the active layer 33 in the first nitride semiconductor light emitting element according to the present invention, Fig. 23(a) is a schematic diagram of a band structure in the case of five pairs of MQWs, Fig. 23(b) is a schematic diagram of a band structure in the case of eight pairs of MQWs, and Fig. 23(c) is a schematic diagram of a band structure in the case of 12 pairs of MQWs.

With the conventional structure, the number of pairs of MQWs is 4 or 5, as shown in Fig. 23(a), the electrons supplied from the n-type semiconductor layer 32 pass through the active layer 33 and flow into the p-type semiconductor layer 34. At this time, the holes to be supplied from the p-type semiconductor layer 34 recombine with the electrons before the holes reach the active layer 33 and thus, the concentration of the holes reaching the active layer 33 decreases. As a result, the luminance of the LED lowers. This happens because, the effective mass of the holes is higher than that of the electrons, and thus mobility of the holes injected from the p-type semiconductor layer 34 is low. For this reason, the electrons reach the p-type semiconductor layer 34 and recombine the holes before the holes reach the active layer 33.

On the other hand, when the number of pairs of MQWs is larger than 12 as shown in Fig. 23(c), due to the thick active layer 33, the electrons supplied from the n-type semiconductor layer 32 cannot sufficiently travel in the active layer 33. At this time, the holes supplied from the p-type semiconductor layer 34 cannot sufficiently travel in the active layer 3, either. For this reason, recombination between the electrons and the holes does not satisfactorily occur in the active layer 33 and thus, the luminance of the LED lowers.

In contrast to these cases, when the number of pairs of MQWs is about eight, as shown in Fig. 22 and Fig. 23(b), the thickness of the active layer 33 is optimized. Here, the electrons supplied from the n-type semiconductor layer 32 can sufficiently travel in the active layer 33 and at the same time, the holes supplied from the p-type semiconductor layer 34 can also sufficiently travel in the active layer 33. As a result, recombination between the electrons and the holes satisfactorily occur in the active layer 33 and thus, the luminance of the LED can be increased.

In the case where the amount of the holes injected from the p-type semiconductor layer 34 to the active layer 33 is sufficiently insured and the amount of the electrons injected from the n-type semiconductor layer 32 to the active layer 33 is also sufficiently insured, the number of pairs of MQWs in the active layer 33 which contribute to the luminous phenomenon may be two or three counting from the p-type semiconductor layer 34. Here the reason for setting a few pairs of MQWs in the active layer 33 on the near side to the p-type semiconductor layer 34 as the pairs of MQW which contribute to the luminous phenomenon is because mobility of the electrons is higher than mobility of the holes.

Furthermore, as shown in Fig. 21, when the number of pairs of MQWs is eight, the light emission output P takes a maximum value P₂, while when the number of pairs of MQWs is 5 or 12, the light emission output P is about P₁ (P₁ < P₂). When the number of pairs of MQWs is smaller than five or larger than 12, it is difficult to secure the sufficient light emission output P.

In the first nitride semiconductor light emitting element according to the present invention, it is possible to optimize the number of pairs of MQWs in the active layer 33 for causing electrons supplied from the n-type semiconductor layer 32 to effectively recombine with holes supplied from the p-type semiconductor layer 34 in the active layer 33.

### (Last Barrier Layer)

The film thickness of the last barrier layer 3310 is set larger than a diffusion distance of Mg from the p-type semiconductor layer 34 to the active layer 33.

In the nitride semiconductor light emitting element shown in Fig. 1, the concentration of the p-type impurity in the last barrier layer 3310 gradually decreases from the first main surface of the last barrier layer 3310 which is in contact with the p-type semiconductor layer 34 in the direction of the film thickness of the last barrier layer 3310 and the p-type impurity does not substantially exists in the second main surface opposed to the first main surface.

The film thickness d0 of the last barrier layer 3310 of the nitride semiconductor light emitting element shown in Fig. 1 is set such that the p-type impurity diffusing from the p-type semiconductor layer 34 to the active layer 33 in the forming process of the p-type semiconductor layer 34 and the subsequent processes does not reach the well layer 332 of the active layer 33. In other words, the film thickness d0 is set to be such thickness that the p-type impurity diffusing from the p-type semiconductor layer 4 to the last barrier layer 3310 does not reach the second main surface (the surface of the last barrier layer 3310 which is in contact with the well layer 332n) opposed to the first main surface of the last barrier layer 3310 which is in contact with the p-type semiconductor layer 34.

The Mg concentration in the first main surface of the last barrier layer 3310 which is in contact with the p-type semiconductor layer 34 is, for example, about 2 × 10²⁰ cm⁻³, gradually decreases toward the second main surface of the last barrier layer 3310 which is opposed to the first main surface, and becomes less than about 10¹⁶ cm⁻³ at the position about 7 to 8 nm away from the first main surface, which finally exerts no effect and falls down to a lower limit for detection of analysis or lower.

In other words, the last barrier layer 3310 having the film thickness do set to about 10 nm does not cause Mg to diffuse to the second main surface of the last barrier layer 3310 and therefore, Mg does not exist in the second main surface of the last barrier layer 3310 which is in contact with the active layer 33. In other words, since Mg does not diffuse into the n^{th} well layer 332n, the luminance of light occurring at the active layer 33 is prevented from lowering.

It should be noted that the film thicknesses d1 to dn respectively of the first barrier layer 3311 to the n^{th} barrier layer 331n may be uniform. However, each of the film thicknesses d1 to dn needs to be set such a thickness that the holes injected from the n-type semiconductor layer 32 to the active layer 33 reach the n^{th} well layer 332n and light emission can occur with recombination between the electrons and the holes in the n^{th} well layer 332n. This is necessary because if the film thicknesses d1 to dn respectively of the first barrier layer 3311 to the n^{th} barrier layer 331n are excessively large, movement of the holes in the active layer 33 is inhibited and thus, the light emitting efficiency lowers. For example, the film thickness do of the last barrier layer 3310 is about 10 nm, each of the film thicknesses d1 to dn of the first barrier layer 3311 to the n^{th} barrier layer 331n is about 7 to 18 nm, and each of the film thicknesses of the first well layer 3321 to n^{th} well layer 332n is about 2 to 3 nm.

As described above, in the nitride semiconductor light emitting element according to the first embodiment of the present invention, the film thickness do of the last barrier layer 3310 which is in contact with the p-type semiconductor layer 34 is set to such a thickness that the p-type impurity diffusing from the p-type semiconductor layer 34 to the active layer 33 does not reach the well layer 332 of the active layer 33. In other words, in the nitride semiconductor light emitting element shown in Fig. 1, by setting the film thickness do of the last barrier layer 3310 to be larger than the diffusion distance of Mg, diffusion of the p-type impurity from the p-type semiconductor layer 34 to the well layer 332 of the active layer 33 is prevented while an increase in the film thickness of the whole active layer 33 is suppressed. As a result, it is possible to manufacture the nitride semiconductor light emitting element, quality of which is prevented from degrading since the luminance of light is not lowered due to the diffusion of the p-type impurity to the well layer 332 which may otherwise occur.

### (Electrode Structure)

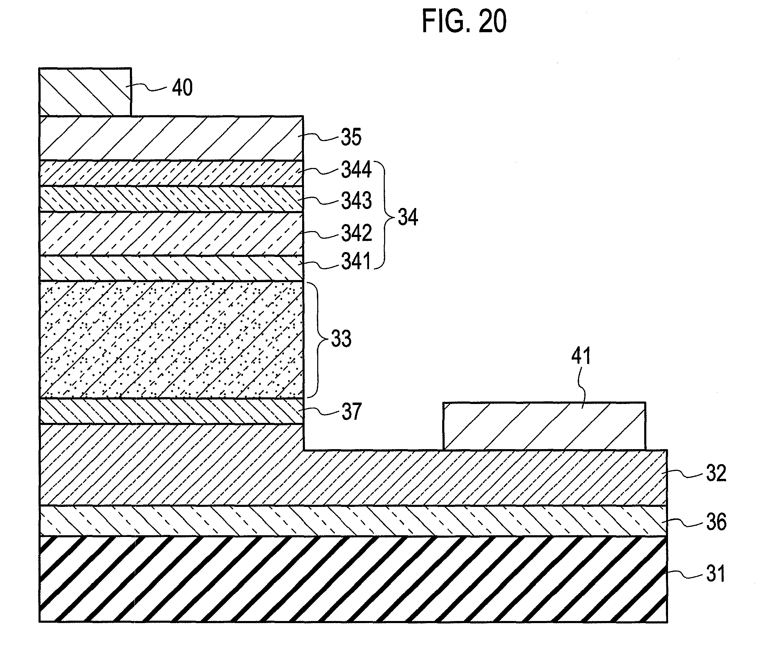

The first nitride semiconductor light emitting element according to the present invention further includes an n-side electrode 41 for applying voltage to the n-type semiconductor layer 32 and a p-side electrode 40 for applying voltage to the p-type semiconductor layer 34, as shown in Fig. 20. A part of each of the p-type semiconductor layer 34, the active layer 33, the block layer 37 and the n-type semiconductor layer 32 is exposed by mesa etching, and the n-side electrode 41 is disposed on the exposed surface of the n-type semiconductor layer 32, as shown in Fig. 20.

The p-side electrode 40 is disposed on top of the p-type semiconductor layer 34 with the oxide electrode 35 interposed in between. Alternatively, the p-side electrode 40 may be disposed directly on top of the p-type semiconductor layer 34. The transparent electrode formed of the oxide electrode 35 disposed on top of the fourth nitride semiconductor layer 344 contains, for example, ZnO, ITO or ZnO containing indium.

The n-side electrode 41 is formed of, for example, an aluminum (Al) film, a multi-layered film of Ti/Ni/Au, Al/Ti/Au,Al/Ni/Au or Al/Ti/Ni/Au, or a multi-layered film of Au-Sn/Ti/Au/Ni/Al stacked in this order from the top. The p-side electrode 40 is formed of, for example, an Al film, a paradium (Pd)- gold (Au) alloy film, a multi-layered film of Ni/Ti/Au, or a multi-layered film of Au-Sn/Ti/Au stacked in this order from the top. The n-side electrode 41 is ohmic connected to the n-type semiconductor layer 32 and the p-side electrode 40 is ohmic connected to the p-type semiconductor layer 34 with the oxide electrode 35 interposed in between.

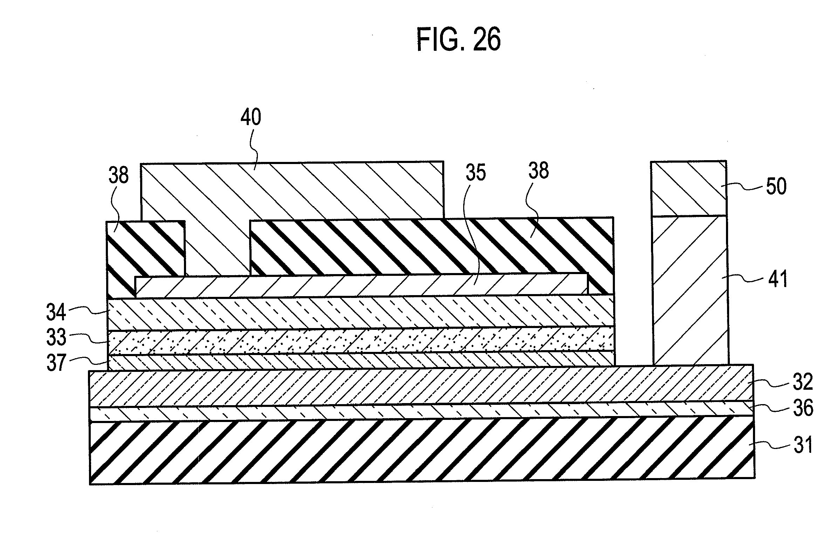

Fig. 26 is a schematic sectional structural diagram of the first nitride semiconductor light emitting element according to the present invention after a forming process of a last electrode. In Fig. 26, to implement the first nitride semiconductor light emitting element according to the present invention on the flip chip structure, the height of the surface of p-side electrode 40 from the substrate 31 is set to be the same as that of the surface of an n-side electrode 50. Like the n-side electrode 41, the n-side electrode 50 formed of, for example, an aluminum (Al) film, a multi-layered film of Ti/Ni/Au, or a multi-layered film of Au-Sn/Ti/Au/Ni/Al stacked in this order from the top.

In the structure shown in Fig. 26, the transparent conductive film ZnO is formed as the oxide electrode 35 and the ZnO is covered with a reflective lamination film 38 which reflects emitted light with the wavelength λ of the light. The reflective lamination film 38 has a layered structure with λ/4n₁ and λ/4n₂ (n₁, n₂ are refractive indexes of layered layers). Materials for the layered structure of the reflective lamination film 38 for blue light having λ = 450 nm, for example, may contain ZrO₂ (n = 2.12) and SiO₂ (n = 1.46). Here, the thickness of the ZrO₂ layer is set to about 53 nm, for example, and the thickness of the SiO₂ layer is set to about 77 nm for example. Examples of the other materials used for the layered structure contain TiO₂, Al₂O₃, and the like.

In the first nitride semiconductor light emitting element according to the present invention, the external light emitting efficiency can be improved since the light produced in the active layer 33 can be taken to the outside by the reflective lamination film 38 without being absorbed by the p-side electrode 40.

### (Manufacturing Method)

An example of a method for manufacturing the first nitride semiconductor light emitting element according to the present invention as shown in Fig. 18 will be described below. The method for manufacturing the nitride semiconductor light emitting element described below is merely an example and as a matter of course, the nitride semiconductor light emitting element can be implemented by the other various manufacturing methods including this modification. Here, an example in which a sapphire substrate is used as the substrate 1 will be described.

(a) First, the AIN buffer layer 36 is grown on the sapphire substrate 31 by the well known metallic organic chemical vapor deposition (MOCVD) method or the like. Trimethyl aluminum (TMA) and ammonia (NH₃) are supplied in a pulsed manner as shown in Fig. 11 to the reaction chamber at a high temperature such as about 900°C to 950°C by using a H₂ gas as the carrier gas so that the thin AIN buffer layer 36 having a thickness of about 10 to 30 Angstrom is grown in a shirt time.

(b) Next, the GaN layer which serves as the n-type semiconductor layer 32 is grown on the AIN buffer layer 36 by the MOCVD method or the like. For example, after thermally cleaning the substrate 31 on which the AlN buffer layer 36 is formed, the substrate temperature is set to about 1000°C and the n-type semiconductor layer 32 doped with the n-type impurity is grown on the AlN buffer layer 36 so as to have a thickness of about 1 to 5 µm. As the n-type semiconductor layer 32, a GaN film doped with Si as the n-type impurity at a concentration of about 3 × 10¹⁸ cm⁻³ can be employed, for example. When Si is doped as the impurity, the n-type semiconductor layer 32 is formed by supplying trimethylgallium (TMG), ammonia (NH₃) and silane (SiH₄) as source gases.

(c) Next, a GaN film doped with Si at a concentration of less than 1 × 10¹⁷ cm⁻³, for example, about 8 × 10¹⁶ cm⁻³ is grown on the n-type semiconductor layer 32 as the block layer 37 so as to have a thickness of, for example, about 200 nm. At this time, the same source gases used in forming the n-type semiconductor layer 32 can be used.

(d) Next, the active layer 33 is formed on the n-type semiconductor layer 32. For example, the active layer 33 is formed by alternately stacking the barrier layer 331 formed of a GaN film and the well layer 332 formed of an InGaN film. Specifically, the barrier layer 331 and the well layer 332 are alternately and continuously grown while adjusting the substrate temperature and flow rate of the source gases appropriate for forming the active layer 33. In this manner, the active layer 33 obtained by stacking the barrier layer 331 and well layer 332 is formed. In other words, the layered structure in which the barrier layer 331 and the well layer 332 are alternately layered is obtained by repeating a unit process n times, for example, eight times, the unit process defined as a process of stacking the well layer 332 and the barrier layer 331 having a larger band gap than the well layer 332 while adjusting the substrate temperature and flow rate of the source gases.

For example, the barrier layer 331 is formed at the substrate temperature Ta and the well layer 332 is formed at the substrate temperature Tb (Ta > Tb). In other words, the first barrier layer 3311 is formed between time points t10 and t11 during which the substrate temperature is set to Ta. Subsequently, the substrate temperature is set to Tb at time point t11 and the first well layer 3321 is formed between time points t11 and t20. Thereafter, in the same way, the second barrier layer 3312 is formed at the substrate temperature Ta between time points t20 and t21, and the second well layer 3322 is formed at the substrate temperature Tb between time points t21 and t30. Then, the n^{th} barrier layer 331n is formed at the substrate temperature Ta between time points tn0 and tn1, and the n^{th} well layer 332n is formed at the substrate temperature Tb between time points tn1 and time te. As a result, the layered structure obtained by alternately stacking the barrier layer 31 and the well layer 32 is completed.

When the barrier layer 331 is formed, the source gasses such as the TMG gas and the NH₃ gas are supplied to the processing device for film formation. When the well layer 332 is formed, the source gases such as the TMG gas, the trimethylindium (TMI) gas, and the NH₃ gas are supplied to the processing device. Here, the TMG gas is supplied as the source gas for Ga atoms, the TMI gas is supplied as the source gas for In atoms, and the NH₃ gas is supplied as the source gas for nitrogen atoms.

An undoped GaN film as the last barrier layer 310 is formed on the layered structure thus formed so as to have a thickness of about 10 nm. The active layer 33 shown in Fig. 1 is formed in this way. As described above, the film thickness do of the last barrier layer 3310 is set to such a thickness that the p-type dopant diffusing from the p-type semiconductor layer 34 to the active layer 33 does not reach the well layer 332 of the active layer 33.

(e) Subsequently, the substrate temperature is set to about 800°C to 900°C and the p-type semiconductor layer 34 doped with the p-type impurity is formed on the last barrier layer 3310 so as to have a thickness of about 0.05 to 1 µm.

The p-type semiconductor layer 34 is formed so as to have a four-layered structure doped with, for example, Mg as the p-type impurity. The first nitride semiconductor layer 341 disposed on top of the active layer 33 is formed of the p-type GaN layer at a concentration of about 2 × 10²⁰ cm⁻³ and a thickness of about 50 nm. The second nitride semiconductor layer 342 is formed of the p-type GaN layer at a concentration of about 4 × 10¹⁹ cm⁻³ and a thickness of about 100 nm. The third nitride semiconductor layer 343 is formed of the p-type GaN layer at a concentration of about 1 × 10²⁰ cm⁻³ and a thickness of about 40 nm. The fourth nitride semiconductor layer 344 is formed of the p-type GaN layer at a concentration of about 8 × 10¹⁹ cm⁻³ and a thickness of about 10 nm.

When Mg is added as the impurity, the TMG gas, the NH₃ gas, and the biscyclopentadienyl magnesium (Cp₂Mg) gas are supplied as the source gases to form the p-type semiconductor layer 34 (341 to 344). Although Mg diffuses from the p-type semiconductor layer 34 (341 to 344) to the active layer 33 in forming the p-type semiconductor layer 34 (341 to 344), the last barrier layer 3310 prevents Mg from diffusing to the well layer 332 of the active layer 33.

Here, the process of forming the p-type semiconductor layer 34 will be described in more detail.

Fig. 24 is a diagram for illustrating a temperature distribution (a) and hydrogen gas flow conditions (b) to (e) in the case where the nitride semiconductor layers (341 to 344) having the four-layered structure is formed in the first nitride semiconductor light emitting element according to the present invention.

Fig. 25 is a diagram for illustrating a temperature distribution (a), a nitrogen gas flow condition (b) and ammonia gas flow condition (c) in the case where the nitride semiconductor layers (341 to 344) having the four-layered structure is formed in the first nitride semiconductor light emitting element according to the present invention.

In each temperature distribution shown in Fig. 24(a) and Fig. 25(a), a period T1 from time points t1 to t2 is a period for forming the first nitride semiconductor layer 341, a period T2 from time points t2 to t3 is a period for forming the second nitride semiconductor layer 342, a period T3 from time points t3 to t4 is a period for forming the third nitride semiconductor layer 343, and a period T4 from time points t4 to t5 is a period for forming the fourth nitride semiconductor layer 344. A period T5 from time points t5 to t6 is a period for decreasing the substrate temperature from 850°C down to 350°C.

The method for manufacturing the nitride semiconductor light emitting element according to the first embodiment of the present invention includes: the step of forming the n-type semiconductor layer 32; the step of forming the active layer 33 on the n-type semiconductor layer 32; and the step of stacking on the active layer 33 multiple p-type GaN layers each containing the p-type impurity to form the nitride semiconductor layer (341 to 344) at a low temperature of about 800°C to 900°C. In the method, at least a part of the multiple p-type GaN layers is formed by supplying the carrier gas containing no hydrogen as the source gas.

If the p-type semiconductor layer 34 is formed by using the carrier gas containing hydrogen, hydrogen atoms taken along with Mg makes Mg inactive and inhibits the p-type GaN layer to be p-typed. To avoid this happening, after the formation of the p-type semiconductor layer 34, annealing for removing the hydrogen atoms to make the p-type semiconductor layer 34 p-typed (hereinafter referred to as "p-type annealing") needs to be performed.

In the method for manufacturing the nitride semiconductor light emitting element according to the first embodiment of the present invention, however, the process of p-type annealing can be omitted for at least one of the first nitride semiconductor layer 341 to fourth nitride semiconductor layer 344, which is formed by supplying the carrier gas containing no hydrogen as the source gas for Mg. It can be set as appropriate as to which part of the p-type semiconductor layer 34 is formed by supplying the carrier gas containing no hydrogen. For example, the first nitride semiconductor layer 341 to third nitride semiconductor layer 343 may be formed by supplying the carrier gas containing no hydrogen and only the fourth nitride semiconductor layer 344 may be formed by supplying the carrier gas containing hydrogen.

In light of the omission of the p-type annealing process, it is preferred that the second nitride semiconductor layer 342 having a large film thickness or the first nitride semiconductor layer 341 at a high Mg concentration, for example, among the first nitride semiconductor layer 341 to fourth nitride semiconductor layer 344 is formed by supplying the carrier gas containing no hydrogen as shown in Fig. 24(b). For example, Fig. 24(c) shows a case where the first nitride semiconductor layer 341 to third nitride semiconductor layer 343 among the first nitride semiconductor layer 41 to fourth nitride semiconductor layer 344 are formed by supplying the carrier gas containing no hydrogen. Fig. 24(d) shows a case where the first nitride semiconductor layer 341 and the third nitride semiconductor layer 343 are formed by supplying the carrier gas containing no hydrogen. Fig. 24(e) shows a case where the second nitride semiconductor layer 342 and the third nitride semiconductor layer 343 are formed by supplying the carrier gas containing no hydrogen.

On the other hand, as shown in Fig. 24(b) to Fig. 24(e), it is preferred that the fourth nitride semiconductor layer 344 which is in contact with the p-side electrodes 40 is formed by supplying the carrier gas containing hydrogen as the source gas for Mg in order to achieve the better crystal state as much as possible. This is because the p-type semiconductor layer doped with Mg generally has the better crystal state in the case where the layer is formed by supplying the carrier gas containing hydrogen as the source gas for Mg, than that obtained in the case of forming the layer by supplying the carrier gas containing no hydrogen.

The description is given below of a method for forming the p-type film in the method for manufacturing the nitride semiconductor light emitting element according to the first embodiment of the present invention. Note that the method for forming the p-type film described below is merely an example and as a matter of course, the film can be implemented by the other various methods including this modification. Here, the description is given as an example of the case where Mg is used as the p-type impurity, and as shown in Fig. 24(b), the first nitride semiconductor layer 341 and the second nitride semiconductor layer 342 are formed by supplying the carrier gas containing no hydrogen and the third nitride semiconductor layer 343 and the fourth nitride semiconductor layer 344 are formed by using the carrier gas containing hydrogen.

As shown in Fig. 24 to Fig. 25, the p-type semiconductor layer 34 is formed at the commonly set substrate temperature Tp of 850°C and pressure of 200 Torr.

### (Step 1)

From time points t1 to time t2, the N₂ gas is supplied as the carrier gas and the NH₃ gas, the TMG gas and the biscyclopentadienyl magnesium (Cp₂Mg) gas as the source gases are supplied to the processing device to form the first nitride semiconductor layer 341. The period between time point t1 to time point t2 lasts for five minutes. The first nitride semiconductor layer 341 having a film thickness of 50 nm and at an Mg concentration of 2 × 10²⁰ cm⁻³ is formed.

### (Step 2)

From time points t2 to time t3, the N₂ gas is supplied as the carrier gas and the NH₃ gas, the TMG gas and the Cp₂Mg gas as the source gases are supplied to the processing device to form the second nitride semiconductor layer 342. The period between time point t2 to time point t3 lasts for 21 minutes. The second nitride semiconductor layer 342 having a film thickness of 100 nm and at an Mg concentration of 4 × 10¹⁹ cm⁻³ is formed.

### (Step 3)

From time points t3 to time t4, H₂ gas and the N₂ gas are supplied as the carrier gas and the NH₃ gas, the TMG gas and the Cp₂Mg gas as the source gases are supplied to the processing device to form the third nitride semiconductor layer 343. The period between time point t3 to time point t4 lasts for 1 minute. The third nitride semiconductor layer 343 having a film thickness of 40 nm and at an Mg concentration of 1 × 10²⁰ cm⁻³ is formed.

### (Step 4)

From time points t4 to time t5, the H₂ gas and the N₂ gas are supplied as the carrier gas and the NH₃ gas, the TMG gas and the Cp₂Mg gas as the source gases are supplied to the processing device to form the fourth nitride semiconductor layer 344. The period between time point t4 to time point t5 lasts for 3 minutes. The fourth nitride semiconductor layer 344 having a film thickness of 10 nm and at an Mg concentration of 8 × 10¹⁹ cm⁻³ is formed.

### (Step 5)

From time points t5 to time t6, the substrate temperature is decreased from the temperature Tp (850°C) down to the temperature of Td (350°C) or less while the N₂ gas is supplied as the carrier gas. In other words, the p-type annealing to be performed at 400°C or higher is not carried out here.

By the above-mentioned steps 1 to 5, the p-type semiconductor layer 34 including the first nitride semiconductor layer 341 to fourth nitride semiconductor layer 344 is formed. Since the first nitride semiconductor layer 341 at a high Mg concentration and the second nitride semiconductor layer 342 having a large film thickness are formed by using the carrier gas containing no H₂ gas, the p-type semiconductor layer 34 can be made as a p-typed semiconductor even without the performance of the p-type annealing. Furthermore, being formed by supplying the carrier gas containing the H₂ gas, the fourth nitride semiconductor layer 344 has the better surface morphology and the better crystal state. In other words, the p-type semiconductor layer 4 has the better crystal state of the surface which is in contact with the p-side electrode 40 is improved, thereby the p-type semiconductor layer 34 and the p-side electrode 40 achieve good contact to each other.

In the above-mentioned process of forming the p-type semiconductor layer 34, H₂ is not taken into the p-type semiconductor layer 34 along with the p-type impurity since the p-type semiconductor layer 34 is formed by supplying the carrier gas containing no H₂ gas. For this reason, the p-type annealing for removing H₂ from the p-type semiconductor layer 34 is not required and thus, the manufacturing process of the nitride semiconductor light emitting element can be shortened.

### (Step 6)

Next, the oxide electrode 35 is formed on top of the p-type semiconductor layer 34 by deposition, a sputtering technique, or the like. For the oxide electrode 35, ZnO, ITO, or ZnO containing indium can be used for example. Furthermore, the n-type impurity such as Ga or Al may be doped at a high concentration of about 1 × 10¹⁹ to 5 × 1021 cm⁻³.

### (Step 7)

Next, after patterning of the oxide electrode 35, the reflective lamination film 38 which reflects emitted light with the wavelength λ is formed so as to cover the oxide electrode 35 by deposition, a sputtering technique, or the like. Materials for the layered structure of the reflective lamination film 38 for blue light having λ = 450 nm, for example, may contain ZrO₂ (n = 2.12) and SiO₂ (n = 1.46). Here, the thickness of the ZrO₂ layer is about 53 nm, for example, and the thickness of the SiO₂ layer is about 77 nm, for example.

### (Step 8)

Subsequently, a part of each of the reflective lamination film 8 and the p-type semiconductor layer 34 to the n-type semiconductor layer 32 is removed by mesa etching according to the etching technique such as reactive ion etching (RIE) to expose the surface of the n-type semiconductor layer 32.

### (Step 9)

Next, the n-side electrodes 41, 50 are formed on the exposed surface of the n-type semiconductor layer 32 by deposition, a sputtering technique or the like. After the patterning of the oxide electrode 35 on the p-type semiconductor layer 34, the p-side electrode 40 is formed on the oxide electrode 35 by deposition, a sputtering technique or the like and thus, the nitride semiconductor light emitting element shown in Fig. 20 is completed.

### (Modification)

Fig. 19(a) is a schematic sectional structural diagram of a modification of the first nitride semiconductor light emitting element according to the present invention and Fig. 2(b) is a schematic enlarged sectional structural diagram of the active layer part.

As shown in Fig. 19, the nitride semiconductor light emitting element as the modification of the first nitride semiconductor light emitting element according to the present invention includes: the substrate 31; the buffer layer 36 disposed on the substrate 31; the n-type semiconductor layer 32 which is disposed on the buffer layer 36 and is doped with the n-type impurity; the block layer 37 which is disposed on the n-type semiconductor layer 32 and is doped with the n-type impurity at a lower concentration than the n-type semiconductor layer 32; the active layer 33 disposed on the block layer 37, the p-type semiconductor layer 34 disposed on the active layer 33; and the oxide electrode 35 disposed on the p-type semiconductor layer 34.

The nitride semiconductor light emitting element as the modification of the first nitride semiconductor light emitting element is characterized by including: the third nitride semiconductor layer 343 including the p-type impurity disposed on top of the active layer 33; the fourth nitride semiconductor layer 344 which is disposed on the third nitride semiconductor layer and contains the p-type impurity at a lower concentration than the p-type impurity in the third nitride semiconductor layer; and the transparent electrode which is disposed on the fourth nitride semiconductor layer and is formed of the oxide electrode 35.

In addition, the transparent electrode is characterized by including ZnO, ITO or ZnO containing indium which is doped with Ga or Al at a concentration of about 1 × 10¹⁹ to 5 × 10²¹ cm⁻³.

Because of the structure of the first nitride semiconductor light emitting element, the nitride semiconductor light emitting element as the modification of the first nitride semiconductor light emitting element is **characterized in that** the p-type semiconductor layer 34 has a two-layered structure formed of the third nitride semiconductor layer disposed on top of the active layer 33 and the fourth nitride semiconductor layer which is disposed on the third nitride semiconductor layer and contains the p-type impurity at a lower concentration than the p-type impurity of the third nitride semiconductor layer.

The third nitride semiconductor layer 343 disposed directly on top of the active layer 33 is formed of, for example, the p-type GaN layer which is doped with Mg at a concentration of about 1 × 10²⁰ cm⁻³ and has a thickness of about 40 nm.

The fourth nitride semiconductor layer 344 which is disposed on the third nitride semiconductor layer 343 and contains the p-type impurity at a lower concentration than the p-type impurity in the third nitride semiconductor layer 343 is formed of, for example, the p-type GaN layer which is doped with Mg at a concentration of about 8 × 10¹⁹ cm⁻³ and has a thickness of about 10 nm.

In the nitride semiconductor light emitting element shown in Fig. 19, as described above, the p-type semiconductor layer 34 formed on the active layer 33 formed of the multi quantum well containing indium is composed of the p-type GaN layer having a structure of two layers at different Mg concentrations and is doped with Mg at the above-mentioned concentration. To reduce thermal damage exerted on the active layer 33, the p-type GaN layer is grown at a low temperature of about 800°C to 900°C.

Since the third nitride semiconductor layer 343 which is the closest to the active layer 33 is a layer which is used to determine the amount of hole injection to the active layer 33, the luminescence intensity becomes higher as the Mg concentration is higher. For this reason, it is desired that the Mg concentration is as high as possible.

The fourth nitride semiconductor layer 344 is a p-type GaN layer for ohmic contact with the oxide electrode 35 and is substantially depleted. When, for example, the ZnO electrode doped with impurity Ga or Al at a concentration of about 1 × 10¹⁹ to 5 × 10²¹ cm⁻³ is used as the oxide electrode 35, the fourth nitride semiconductor layer 344 is doped with the impurity Mg of the Mg concentration, which is equivalent to that at the time when the forward voltage V_{f} of the nitride semiconductor light emitting element is the lowest.

When 34 p-type GaN layers are to be grown, the amount of a H₂ gas in the carrier gas is increased since the third nitride semiconductor layer 343 and the fourth nitride semiconductor layer 344 which are close to the p electrode 40 need to have the hole concentration thereof increased. On the other hand, the amount of H₂ gas in the carrier gas do not need to be increased for the third nitride semiconductor layer 343 which is close to the active layer 33, and the third nitride semiconductor layer 343 may crystal grown with the N₂ carrier gas having the same conditions for the growth of the active layer 33.

The description is omitted of the AIN buffer layer 36, the n-type semiconductor layer 32, the block layer 37, the active layer 33, the p-type semiconductor layer 34, the last barrier layer 3310, the reflective lamination film 38, and the electrode structure in the above-mentioned nitride semiconductor light emitting element as a modification of the first nitride semiconductor light emitting element according to the present invention, since these are the same as those of the first nitride semiconductor light emitting element according to the present invention.

The nitride semiconductor light emitting element as the modification of the first nitride semiconductor light emitting element according to the present invention is able to do the followings. Specifically, the crystal quality and surface morphology of the III group nitride semiconductor formed on the high temperature AIN buffer layer can be improved. The p-type semiconductor layer can be formed at a low temperature, thereby reducing thermal damage exerted on the active layer, lowering the forward voltage V_{f}, and improving the light emitting efficiency. The number of pairs of MQWs in the active layer can be optimized, the number of pairs of MQWs used for effectively recombining the electrons supplied from the n-type semiconductor layer with the holes supplied from the p-type semiconductor layer in the active layer, thereby improving the light emitting efficiency. The p-type impurity is prevented from diffusing from the p-type semiconductor layer to the well layer, thereby improving the light emitting efficiency Electron overflow from the n-type semiconductor layer to the p-type semiconductor layer and diffusion of the n-type impurity from the n-type semiconductor layer to the active layer can be suppressed, thereby improving the light emitting efficiency. The nitride semiconductor light emitting element requiring no annealing process of removing hydrogen atoms from the p-type semiconductor layer can be provided and the nitride semiconductor light emitting element with the external light emitting efficiency improved by the reflective lamination film can be provided.

### [Other Embodiment]

Although the first embodiment of the present invention has been described as above, the description and the drawings which form part of this disclosure do not limit the present invention. From this disclosure, various alternative embodiments, examples and operating techniques are apparent to those skilled in the art.

The above-mentioned description for the embodiment is made taking a case of the MQW structure in which the active layer 33 has multiple well layers 332 each sandwiched between each adjacent two barrier layers 331. However, other structure may be applicable in which the active layer 33 includes one well layer 332 and the film thickness do of the last barrier layer 3310 disposed between the well layer 332 and the p-type semiconductor layer 34 may be made larger than the diffusion distance of Mg.

As described above, as a matter of course, the present invention includes various embodiments which are not described herein. Therefore, the technical scope of the present invention is defined by only inventive matters to be specified according to the scope of claims as appropriate from the above-mentioned description.

## Claims

1. An nitride semiconductor light emitting element wherein an n-type AlGaN cladding layer is formed on an AlN buffer layer.

2. The nitride semiconductor light emitting element according to claim 1, wherein the n-type AlGaN cladding layer also serves as a contact layer which is in contact with an electrode.

3. The nitride semiconductor light emitting element according to any one of claims 1 and 2, wherein
an active layer having a quantum well structure is formed on the n-type AlGaN cladding layer, and
the active layer is formed of an Al_{X1}In_{Y1}Ga_{Z1}N well layer (X1 + Y1 + Z1= 1, 0 < X1 < 1, 0 < Y1 < 1, 0 < Z1 < 1) and an Al_{X2}Ga_{Y2}N barrier layer (X2 + Y2 = 1, 0 < X2 < 1, 0 <Y2<1).

4. The nitride semiconductor light emitting element according to claim 3, wherein the active layer is doped with an n-type impurity at a concentration of less than 10¹⁷ cm⁻³.

5. The nitride semiconductor light emitting element according to any one of claims 3 and 4, wherein any one of a p-type AlInGaN cladding layer and a p-type AlInGaN/InGaN superlattice cladding layer is formed on the active layer.

6. The nitride semiconductor light emitting element according to claim 5, wherein a p-type GaN contact layer which is in contact with a p electrode is formed between the p-type cladding layer and the p electrode.

7. The nitride semiconductor light emitting element according to claim 6, wherein
the p-type GaN contact layer has a multi-layered structure obtained by stacking a first p-type GaN layer, a second p-type GaN layer, a third p-type GaN layer, and a fourth p-type GaN layer from the side close to the p-type cladding layer in this order, and
the p-type impurity concentration of the second p-type GaN layer is lower than that of the first p-type GaN layer, the p-type impurity concentration of the third p-type GaN layer is higher than that of the second p-type GaN layer, and the p-type impurity concentration of the fourth p-type GaN layer is lower than that of the third p-type GaN layer.

8. The nitride semiconductor light emitting element according to any one of claims 1 to 7, wherein the AIN buffer layer is formed at a growth temperature of 900°C or higher.

9. A nitride semiconductor light emitting element comprising:
a substrate;
an AIN buffer layer disposed on the substrate;
an n-type semiconductor layer which is disposed on the AIN buffer layer and is doped with an n-type impurity;
a block layer which is disposed on the n-type semiconductor layer and is doped with the n-type impurity at a lower concentration than that of the n-type semiconductor layer;
an active layer which is disposed on the block layer, has a layered structure obtained by alternately disposing a barrier layer and a well layer having a smaller band gap than the barrier layer, and is formed of a multi quantum well containing indium;
a first nitride semiconductor layer which is disposed on the active layer and contains a p-type impurity;
a second nitride semiconductor layer which is disposed on the first nitride semiconductor layer and contains a p-type impurity at a lower concentration than the p-type impurity in the first nitride semiconductor layer;
a third nitride semiconductor layer which is disposed on the second nitride semiconductor layer and contains a p-type impurity at a higher concentration than the p-type impurity in the second nitride semiconductor layer; and
a fourth nitride semiconductor layer which is disposed on the third nitride semiconductor layer and contains a p-type impurity at a lower concentration than the p-type impurity in the third nitride semiconductor layer, wherein
the film thickness of a last barrier layer which is the topmost layer in the layered structure is larger than a diffusion distance of the p-type impurity in the first nitride semiconductor layer.

10. The nitride semiconductor light emitting element according to claim 9, wherein the thickness of the second nitride semiconductor layer is formed to be larger than the thickness of any one of the first nitride semiconductor layer, the third nitride semiconductor layer, and the fourth nitride semiconductor layer.

11. The nitride semiconductor light emitting element according to any one of claims 9 and 10, further comprising a transparent electrode which is disposed on the fourth nitride semiconductor layer and is formed of an oxide electrode.

12. The nitride semiconductor light emitting element according to claim 11, wherein the transparent electrode contains any one of ZnO, ITO and ZnO containing indium.

13. The nitride semiconductor light emitting element according to claim 11, wherein the transparent electrode contains any one of ZnO, ITO and ZnO containing indium, which is doped with Ga or A1 at an impurity concentration of 1 × 10¹⁹ to 5 × 10²¹ cm⁻³.

14. The nitride semiconductor light emitting element according to any one of claims 9 to 13, wherein the barrier layer is made of GaN, the well layer is made of InₓGa₁₋ₓN (0 < x < 1), and the number of pairs of the multi quantum wells is 6 to 11.

15. The nitride semiconductor light emitting element according to claim 14, wherein the thickness of the well layer is 2 to 3 nm and the thickness of the barrier layer is 15 to 18 nm.

16. The nitride semiconductor light emitting element according to any one of claims 9 to 15, wherein the concentration of the p-type impurity in the last barrier layer gradually decreases from a first main surface of the last barrier layer in a direction of the film thickness of the last barrier layer, the first main surface being in contact with the p-type semiconductor layer, and
the concentration of the p-type impurity is less than 1 × 10¹⁶ cm⁻³ in a second main surface opposed to the first main surface.

17. The nitride semiconductor light emitting element according to any one of claims 9 to 16, wherein the last barrier layer is made of GaN.

18. The nitride semiconductor light emitting element according to any one of claims 9 to 17, wherein the p-type impurity is magnesium.

19. The nitride semiconductor light emitting element according to any one of claims 9 to 18, wherein the n-type impurity is silicon.

20. The nitride semiconductor light emitting element according to claim 19, wherein the silicon concentration of the block layer is less than 1 × 10¹⁷ cm⁻³.

21. The nitride semiconductor light emitting element according to any one of claims 9 to 20, wherein the first to fourth nitride semiconductor layers are formed by growing GaN at a low temperature of 800°C to 900°C.

22. A nitride semiconductor light emitting element comprising:
a substrate;
an AlN buffer layer disposed on the substrate;
an n-type semiconductor layer which is disposed on the AIN buffer layer and is doped with an n-type impurity;
a block layer which is disposed on the n-type semiconductor layer and is doped with the n-type impurity at a lower concentration than that of the n-type semiconductor layer;
an active layer which is disposed on the block layer, has a layered structure obtained by alternately disposing a barrier layer and a well layer having a smaller band gap than the barrier layer, and is formed of a multi quantum well containing indium;
a first nitride semiconductor layer which is disposed on the active layer and contains a p-type impurity;
a second nitride semiconductor layer which is disposed on the first nitride semiconductor layer and contains a p-type impurity at a lower concentration than the p-type impurity in the first nitride semiconductor layer; and
a transparent electrode which is disposed on the second nitride semiconductor layer and is formed of an oxide electrode, wherein
the film thickness of a last barrier layer which is the topmost layer in the layered structure is larger than a diffusion distance of the p-type impurity in the first nitride semiconductor layer.

23. The nitride semiconductor light emitting element according to claim 22, wherein the transparent electrode contains any one of ZnO, ITO and ZnO containing indium.

24. The nitride semiconductor light emitting element according to claim 22, wherein the transparent electrode contains any one of ZnO, ITO and ZnO containing indium, which is doped with Ga or Al at an impurity concentration of 10²¹ cm⁻³.

25. The nitride semiconductor light emitting element according to any one of claims 22 to 24, wherein the barrier layer is made of GaN, the well layer is made of InₓGa₁₋ₓN (0 < x < 1), and the number of pairs of the multi quantum wells is 6 to 11.

26. The nitride semiconductor light emitting element according to claim 25, wherein the thickness of the well layer is 2 to 3 nm and the thickness of the barrier layer is 15 to 18 nm.

27. The nitride semiconductor light emitting element according to any one of claims 22 to 26, wherein the concentration of the p-type impurity in the last barrier layer gradually decreases from a first main surface of the last barrier layer in a direction of the film thickness of the last barrier layer, the first main surface being in contact with the p-type semiconductor layer, and
the concentration of the p-type impurity is less than 1 × 10¹⁶ cm⁻³ in a second main surface opposed to the first main surface.

28. The nitride semiconductor light emitting element according to any one of claims 22 to 27, wherein the last barrier layer is made of GaN.

29. The nitride semiconductor light emitting element according to any one of claims 22 to 28, wherein the p-type impurity is magnesium.

30. The nitride semiconductor light emitting element according to any one of claims 22 to 29, wherein the n-type impurity is silicon.

31. The nitride semiconductor light emitting element according to claim 30, wherein the silicon concentration of the block layer is less than 1 × 10¹⁷ cm⁻³.

32. The nitride semiconductor light emitting element according to any one of claims 22 to 30, wherein the first and second nitride semiconductor layers are formed of by growing GaN at a low temperature of 800°C to 900°C.

33. The nitride semiconductor light emitting element according to any one of claims 9 to 32, wherein the substrate is made of sapphire.

34. The nitride semiconductor light emitting element according to any one of claims 11 to 13 and claims 22 to 24, further comprising a reflective lamination film provided on the transparent electrode.

35. The nitride semiconductor light emitting element according to claim 34, wherein the semiconductor element has a flip chip structure and light reflected on the reflective lamination film is taken out from the substrate side.

36. A method for manufacturing a nitride semiconductor by growing a nitride semiconductor crystal on an AlN buffer layer, wherein
the AlN buffer layer is formed by alternately supplying an Al material and an N material at a growth temperature of 900°C or higher.

37. The method for manufacturing a nitride semiconductor according to claim 36, wherein the film thickness of the AlN buffer layer is formed to fall within the range of 10Å to 50 Å.
